# EUROPEAN PATENT SPECIFICATION

(11) **EP 4 546 344 B1**
(45) Date of publication and mention of the grant of the patent: **04.11.2026**
(21) Application number: 24204839.5
(22) Date of filing: 04.10.2024
(51) Int. Cl.: G11C 29/02, G11C 5/02, G11C 29/50

(54) **MEMORY DEVICE HAVING CELL OVER PERIPHERY STRUCTURE AND COMPENSATION FOR MISALIGNMENT OF BONDING STRUCTURE BY INTEGRATED TEST CIRCUIT**
SPEICHERANORDNUNG MIT ZELLEN-ÜBER-PERIPHERIE-STRUKTUR UND KOMPENSATION VON AUSRICHTUNGSFEHLERN DER BONDING-STRUKTUR DURCH INTEGRIERTE TESTSCHALTUNG
DISPOSITIF DE MÉMOIRE AYANT UNE STRUCTURE DE CELLULE SUR LA PÉRIPHÉRIE ET COMPENSATION DU DÉSALIGNEMENT DE LA STRUCTURE DE LIAISON PAR UN CIRCUIT DE TEST INTÉGRÉ

(30) Priority: 27.10.2023 KR 20230145459
(43) Date of publication of application: 30.04.2025
(73) Proprietor: Samsung Electronics Co., Ltd., Suwon-si, Gyeonggi-do 16677 (KR)
(72) Inventor: LEE, Changyoung, 16677 Suwon-si (KR); JUNG, Sanghoon, 16677 Suwon-si (KR); YOO, Changsik, 16677 Suwon-si (KR)
(74) Representative: Marks & Clerk LLP

(56) References cited:
- US-A1- 2021 066 143
- US-A1- 2021 090 663
- US-A1- 2021 098 424
- US-A1- 2021 257 266

## Description

### BACKGROUND

Semiconductor memory devices may be divided into two categories depending upon whether or not they retain stored data when disconnected from a power supply. These categories include volatile memory devices, which lose stored data when disconnected from power, and nonvolatile memory devices, which retain stored data when disconnected from power. While volatile memory devices may perform read and write operations at a high speed, contents stored therein may be lost at power-off. Since nonvolatile memory devices retain contents stored therein even at power-off, they may be used to store data that needs to be retained.

Various structures are being adopted to increase the integration degree of memory devices and reduce the size of memory devices. However, the reduction of the size of memory devices is limited because the memory device should still include a peripheral circuit for driving a memory cell array and a wiring structure to electrically connect the memory cell array with the peripheral circuit. Recently, methods are used in which elements included in the memory device are fabricated on separate wafers, rather than being fabricated on a single wafer, and then bonded to each other.

US 2021/090663 discloses a memory device which has a chip-to-chip bonding structure being capable of detecting a misalignment failure that occurs during the bonding of chips.

US 2021/257266 A1 discloses a memory system including structural elements that can mitigate a voltage drop representative if a wafer misalignment occurs by providing a boost voltage.

### SUMMARY

The present disclosure relates to a memory device capable of efficiently reducing size, easily detecting defects, and/or preventing performance degradation, and a semiconductor device capable of efficiently reducing size, easily detecting defects, and/or preventing performance degradation. The present invention is defined in independent claim 1. Selected optional features are recited in the dependent claims. Only embodiments or examples comprising all features of claim 1 fall under the scope of protection of the present invention, while the remaining ones correspond to illustrative examples which are useful for the understanding of the relevant technical context.

In general, according to some aspects, a memory device includes a first semiconductor layer and a second semiconductor layer. The first semiconductor layer includes a memory cell array, a first bonding pad and a first test pad. The memory cell array is connected to a plurality of wordlines extending in a first direction and a plurality of bitlines extending in a second direction crossing the first direction. The second semiconductor layer is disposed with respect to the first semiconductor layer in a third direction perpendicular to both the first direction and the second direction, and includes a peripheral circuit, a second bonding pad, a second test pad and a test circuit. The peripheral circuit controls the memory cell array. The second bonding pad is connected to the first bonding pad. The second test pad is connected to the first test pad. The test circuit checks a connection state of the first and second bonding pads. The test circuit receives a first test signal through the first and second test pads, generates a first test result signal based on the first test signal, and compensates an operation of the peripheral circuit based on the first test result signal. The first test result signal represents a first misalignment between the first and second bonding pads.

In general, according to some aspects, a memory device includes a first semiconductor layer and a second semiconductor layer. The first semiconductor layer includes a memory cell array, a first bonding pad, a second bonding pad, a first test pad and a second test pad. The memory cell array is connected to a plurality of wordlines extending in a first direction and a plurality of bitlines extending in a second direction crossing the first direction. The second semiconductor layer is disposed with respect to the first semiconductor layer in a third direction perpendicular to both the first direction and the second direction, and includes a peripheral circuit, a third bonding pad, a fourth bonding pad, a third test pad, a fourth test pad and a test circuit. The peripheral circuit controls the memory cell array. The third bonding pad and the fourth bonding pad are connected to the first bonding pad and the second bonding pad, respectively. The third test pad and a fourth test pad are connected to the first test pad and the second test pad, respectively. The test circuit checks a connection state of the first and second bonding pads and a connection state of the third and fourth bonding pads. The first and third bonding pads and the first and third test pads are disposed to correspond to a first region of the memory cell array. The second and fourth bonding pads and the second and fourth test pads are disposed to correspond to a second region different from the first region of the memory cell array. When it is determined, based on a first test signal provided through the first and third test pads, that a misalignment between the first and third bonding pads has occurred with a first level that is a compensable level, the test circuit controls an operation of the peripheral circuit such that at least one of a sensing time of the first region of the memory cell array and a first operating voltage supplied to the first region of the memory cell array is adjusted. When it is determined, based on a second test signal provided through the second and fourth test pads, that a misalignment between the second and fourth bonding pads has occurred with a second level that is an uncompensable level, the test circuit screens a usage of the second region of the memory cell array, or repairs the second region of the memory cell array to another region of the memory cell array.

In general, according to some aspects, a semiconductor device includes a first semiconductor layer and a second semiconductor layer. The first semiconductor layer includes a first circuit, a first bonding pad and a first test pad. The second semiconductor layer is disposed with respect to the first semiconductor layer in a vertical direction, and includes a second circuit, a second bonding pad, a second test pad and a test circuit. The second circuit is interoperable with the first circuit. The second bonding pad is connected to the first bonding pad. The second test pad is connected to the first test pad. The test circuit checks a connection state of the first and second bonding pads. The test circuit receives a first test signal through the first and second test pads, generates a first test result signal based on the first test signal, and compensates an operation of the second circuit based on the first test result signal. The first test result signal represents a misalignment between the first and second bonding pads.

In some implementations, the memory device may have or adopt a structure in which the peripheral circuit and the memory cell array are stacked, e.g., a cell over periphery (COP) structure in which the peripheral circuit is formed below and then the memory cell array is stacked on the peripheral circuit. Accordingly, the memory device may have a relatively small size.

In some implementations, the memory device and the semiconductor device may further includes the test pads formed separately, independently and/or individually from the bonding pads, and may further include the test circuit connected to the test pads. It may be determined, using the test pads and the test circuit, whether the misalignment between the bonding pads occurred, and appropriate feedback operations such as screening, repairing and adjusting operation conditions may be performed depending on the degree of the misalignment. Accordingly, the defects in the memory device may be relatively easily detected, and the performance degradation of the memory device may be effectively prevented.

While the test circuit has been described as being configured to compensate an operation of the peripheral circuit or second circuit based on the first test result signal, the test circuit may alternatively or additionally be configured to compensate an operation of the memory cell array of first circuit. For example, the test circuit may be configured to adjust a sending time and/or operating voltage of the memory cell array. Still further, the test circuit may be configured to screen usage of the memory cell array, e.g., screen usage of a region of the memory cell array, and/or repair the memory cell array, e.g., repair a region of the memory cell array to another region of the memory cell array..

At least some of the above and other features of the disclosure are set out in the claims.

### BRIEF DESCRIPTION OF THE DRAWINGS

Illustrative, non-limiting example implementations will be more clearly understood from the following detailed description taken in conjunction with the accompanying drawings.
FIG. 1 is a perspective view of an example of a memory device.
FIG. 2 is a cross-sectional view of an example of a memory device.
FIGS. 3A, 3B, and 3C are diagrams for describing an example of a memory device.
FIG. 4 is a block diagram illustrating an example of a memory device.
FIGS. 5A, 5B, and 5C are diagrams illustrating examples of a memory cell array included in a memory device of FIG. 4.
FIGS. 6A, 6B, 6C, 7A, 7B, and 7C are diagrams illustrating examples of bonding pads, test pads and a test circuit that are included in a memory device.
FIG. 8 is a block diagram illustrating an example of a test circuit included in a memory device.
FIGS. 9A, 9B, 10A, and 10B are diagrams illustrating examples of a plurality of sense amplifiers included in a test circuit of FIG. 8.
FIGS. 11A, 11B, and 11C are diagrams for describing an example of an operation of a memory device using a test circuit of FIG. 8.
FIG. 12 is a block diagram illustrating an example of a storage unit included in a test circuit of FIG. 8.
FIGS. 13A and 13B are block diagrams illustrating examples of a test circuit included in a memory device.
FIG. 14 is a block diagram illustrating an example of a storage unit included in test circuits of FIGS. 13A and 13B.
FIGS. 15A, 15B, and 15C are diagrams for describing an example of a memory device.
FIGS. 16A, 16B, 16C, and 16D are diagrams for describing an example of an operation of a memory device.
FIGS. 17A and 17B are diagrams for describing an example of a memory device.
FIGS. 18A, 18B, and 18C are example perspective views of a memory device and a semiconductor device.
FIGS. 19A and 19B are cross-sectional views of an example of a memory package.
FIG. 20 is a block diagram illustrating an example of a memory system.
FIG. 21 is a flowchart illustrating an example of a method of operating a memory device.

### DETAILED DESCRIPTION

Various example implementations will be described more fully with reference to the accompanying drawings, in which implementations are shown. The present disclosure may, however, be implemented in many different forms and should not be construed as limited to the implementations set forth herein. Like reference numerals refer to like elements throughout this application.

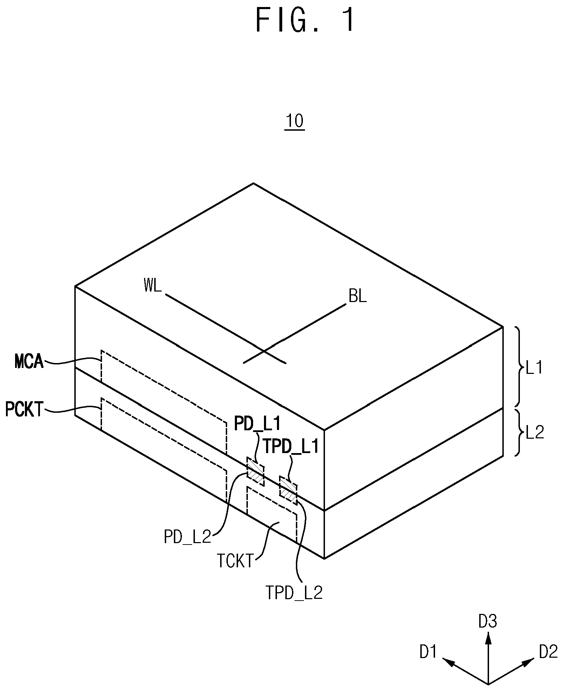

FIG. 1 is a perspective view of an example of a memory device.

In FIG. 1, two directions that are each parallel or substantially parallel to a first surface (e.g., a top surface) of a substrate and crossing each other are referred to as a first direction D1 (e.g., an X-axis direction) and a second direction D2 (e.g., a Y-axis direction). The two directions D1, D2 may be perpendicular to each other. In addition, a direction vertical or substantially vertical to the first surface of the substrate is referred to as a third direction D3 (e.g., a Z-axis direction). For example, the first and second directions D1 and D2 may be perpendicular or substantially perpendicular to each other. In addition, the third direction D3 may be perpendicular or substantially perpendicular to both the first and second directions D1 and D2. Further, a direction indicated by an arrow in the figures and a reverse direction thereof are considered as the same direction. The definition of the first, second and third directions D1, D2 and D3 are same in the subsequent figures.

Referring to FIG. 1, a memory device 10 includes a first semiconductor layer L1 and a second semiconductor layer L2.

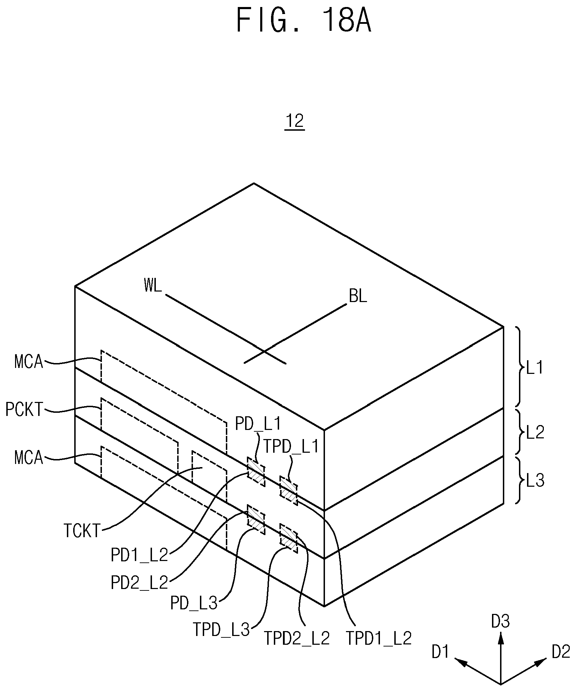

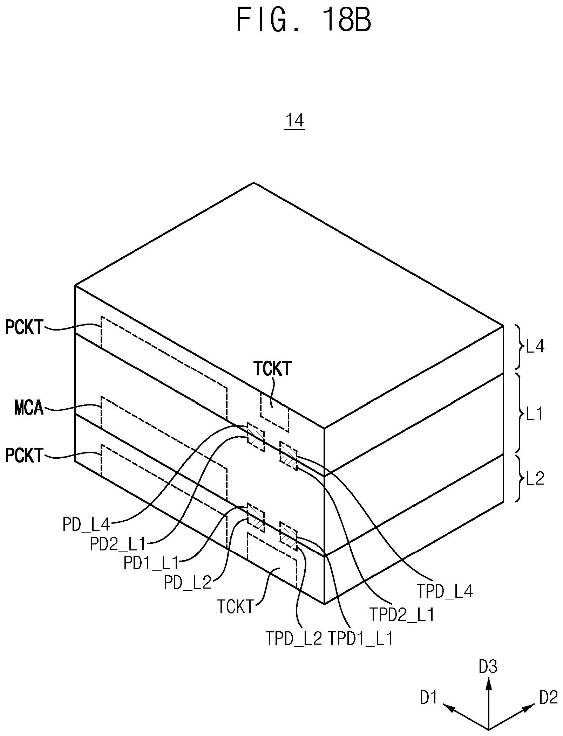

The first semiconductor layer L1 and the second semiconductor layer L2 are disposed or stacked in the third direction D3. For example, the first semiconductor layer L1 may be stacked on the second semiconductor layer L2 in the third direction D3, and the second semiconductor layer L2 may be disposed under (e.g., directly beneath or indirectly beneath) the first semiconductor layer L1 in the third direction D3. The first semiconductor layer L1 may completely overlay the second semiconductor layer L2 or may partially overlay the second semiconductor layer L2. However, implementations are not limited thereto. For example, the memory device 10 may be turned over during the manufacturing process, and thus the second semiconductor layer L2 may be stacked on the first semiconductor layer L1 in the third direction D3. In some implementations, as will be described with reference to FIGS. 18A and 18B, three or more semiconductor layers may be stacked in the third direction D3.

The first semiconductor layer L1 includes a plurality of wordlines WL, a plurality of bitlines and a first circuit, which in this arrangement comprises a memory cell array MCA. Thus, the first semiconductor layer L1 may be referred to as a memory cell region (MCR).

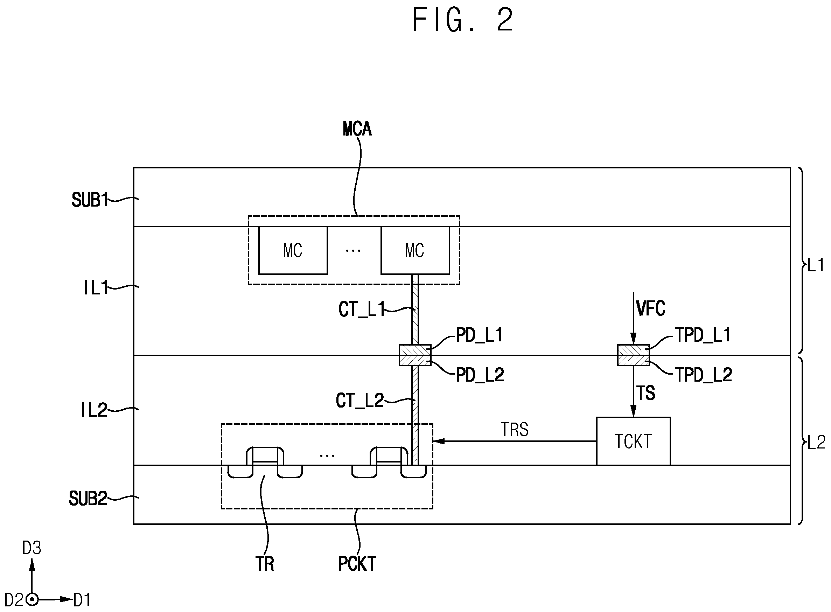

For example, as will be described with reference to FIG. 2, the first semiconductor layer L1 may include a first substrate. The plurality of wordlines WL, the plurality of bitlines BL and the memory cell array MCA may be disposed and/or formed on the first substrate. For example, each of the plurality of wordlines WL may extend in the first direction D1, and the plurality of wordlines WL may be arranged along the second direction D2. For example, each of the plurality of bitlines BL may extend in the second direction D2, and the plurality of bitlines BL may be arranged along the first direction D1. For example, the memory cell array MCA may be connected to the plurality of wordlines WL and the plurality of bitlines BL.

The second semiconductor layer L2 includes a second circuit which in this arrangement comprises a peripheral circuit PCKT that controls the memory cell array MCA. Thus, the second semiconductor layer L2 may be referred to as a peripheral circuit region (PCR).

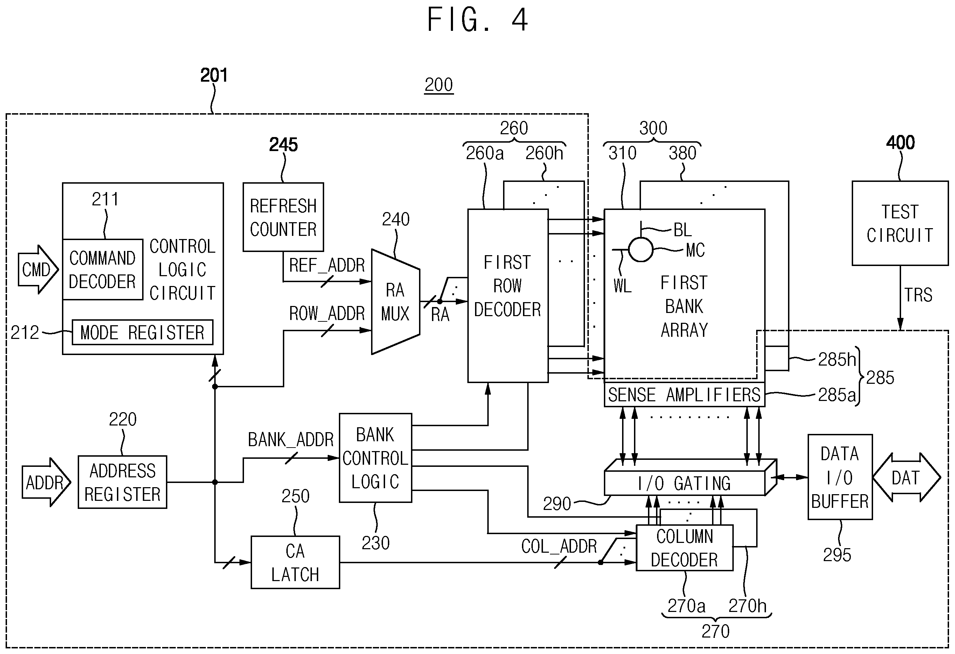

For example, as will be described with reference to FIG. 2, the second semiconductor layer L2 may include a second substrate. The peripheral circuit PCKT may be disposed and/or formed on the second substrate. For example, as will be described with reference to FIG. 4, the peripheral circuit PCKT may include a control logic circuit, a sense amplifier unit, and/or the like.

The first semiconductor layer L1 includes a first bonding pad PD_L1, and the second semiconductor layer L2 includes a second bonding pad PD_L2. The second bonding pad PD_L2 is connected to the first bonding pad PD_L1. The memory cell array MCA (e.g., the wordlines WL and the bitlines BL) of the first semiconductor layer L1 and the peripheral circuit PCKT of the second semiconductor layer L2 may be electrically connected to each other by the first and second bonding pads PD_L1 and PD_L2.

In some implementations, the first semiconductor layer L1 and the second semiconductor layer L2 may be manufactured separately, and then the first semiconductor layer L1 and the second semiconductor layer L2 may be connected to each other by a bonding scheme (or method). For example, the bonding scheme may represent a method of electrically or physically connecting a bonding metal pattern (e.g., the first bonding pad PD_L1) formed in the first semiconductor layer L1 to a bonding metal pattern (e.g., the second bonding pad PD_L2) formed in the second semiconductor layer L2. For example, the bonding pads PD_L1 and PD_L2 may be formed of copper (Cu), and the bonding scheme may be a Cu-Cu bonding scheme. Alternatively, the bonding pads PD_L1 and PD_L2 may be formed of aluminum (Al) or tungsten (W).

The first semiconductor layer L1 includes a first test pad TPD_L1, and the second semiconductor layer L2 includes a second test pad TPD_L2 and a test circuit TCKT. The second test pad TPD_L2 is connected to the first test pad TPD_L1. For example, the first and second test pads TPD_L1 and TPD_L2 may be formed by the same material and the same process as the first and second bonding pads PD_L1 and PD_L2. The test circuit TCKT checks a connection state (or status) of the first and second bonding pads PD_L1 and PD_L2. For example, the test circuit TCKT may determine whether the connection state of the first and second bonding pads PD_L1 and PD_L2 is normal or abnormal by checking a connection state of the first and second test pads TPD_L1 and TPD_L2. The test circuit TCKT may determine whether the connection state of at least one of the first and second bonding pads PD_L1 and PD_L2 is normal or abnormal by checking a connection state of at least one of the first and second test pads TPD_L1 and TPD_L2. For example, the test circuit TCKT may determine whether the connection state of the first bonding pad PD_L1 is normal or abnormal by checking the connection state of the first test pad TPD_L1. A connection state of the first and second bonding pads PD_L1, PD_L2 may comprise a degree to which the first and second bonding pads PD_L1, PD_L2 are connected (i.e., bonded) to each other. The connection state may be affected by misalignment between the bonding pads PD_L1, PD_L2. For example, if the bonding pads PD_L1, PD_L2 are misaligned, even to a small degree, the connection state may be less than stable than if the bonding pads PD_L1, PD_L2 are fully alignment. Alignment may refer to alignment in the third direction D3 (e.g., Z-axis direction).

FIG. 2 is a cross-sectional view of an example of a memory device.

Referring to FIGS. 1 and 2, the first semiconductor layer L1 may include a first substrate SUB1, the memory cell array MCA, the first bonding pad PD_L1, the first test pad TPD_L1, a first contact CT_L1 and a first insulating layer IL1. The second semiconductor layer L2 may include a second substrate SUB2, the peripheral circuit PCKT, the second bonding pad PD_L2, the second test pad TPD_L2, the test circuit TCKT, a second contact CT_L2 and a second insulating layer IL2.

The first substrate SUB1 may be a supporting layer that supports components (or elements) of the first semiconductor layer L1, and the second substrate SUB2 may be a supporting layer that supports components of the second semiconductor layer L2. For example, each of the first and second substrates SUB1 and SUB2 may be a silicon substrate, and may be referred to as a base substrate. The first insulating layer IL1 may cover the components of the first semiconductor layer L1, and the second insulating layer IL2 may cover the components of the second semiconductor layer L2.

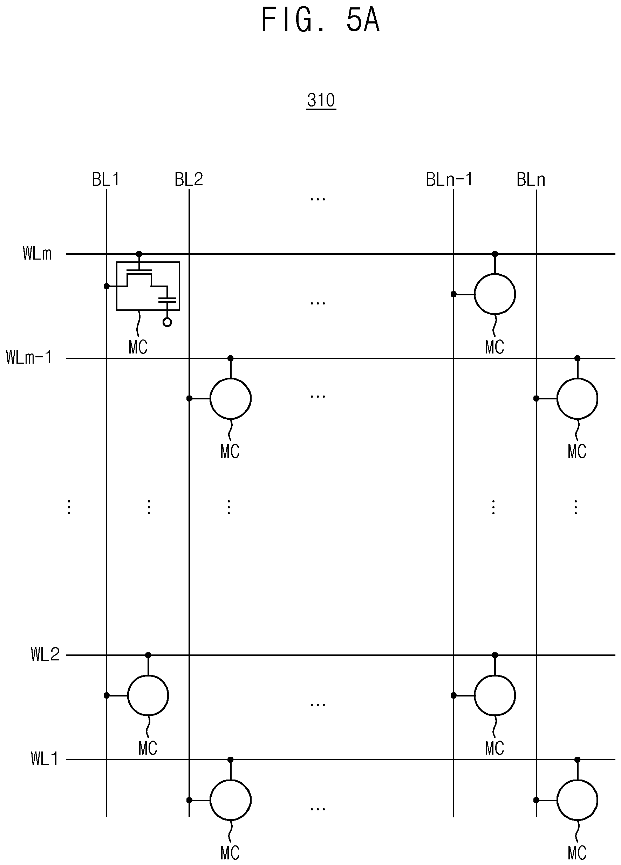

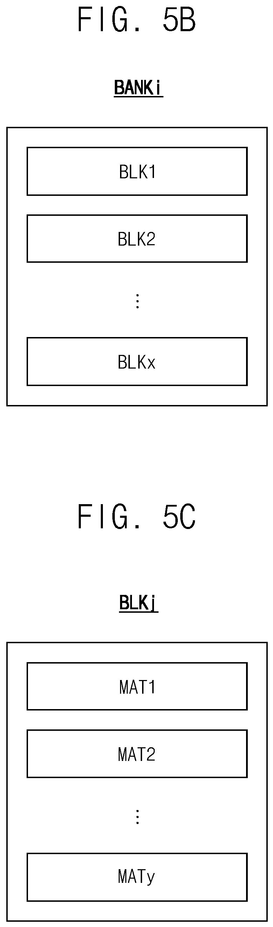

The memory cell array MCA may include a plurality of memory cells MC, and the peripheral circuit PCKT may include a plurality of transistors TR. For example, as will be described with reference to FIGS. 4, 5A, 5B and 5C, at least some of the plurality of memory cells MC may be grouped into a mat, a block, a bank, or the like, and various types of circuits may be implemented by the plurality of transistors TR.

The memory cell MC and the transistor TR may be electrically connected to each other by the first and second contacts CT_L1 and CT_L2 and the first and second bonding pads PD_L1 and PD_L2. For example, the memory cell MC may be electrically connected to the first contact CT_L1 and the first bonding pad PD_L1, the transistor TR may be electrically connected to the second contact CT_L2 and the second bonding pad PD_L2, and the memory cell MC and the transistor TR may be electrically connected to each other by electrically connecting the first bonding pad PD_L1 with the second bonding pad PD_L2. Although not illustrated in detail, at least one conductive line and/or contact may be further formed to connect the memory cell MC with the first bonding pad PD_L1, and at least one conductive line and/or contact may be further formed to connect the transistor TR with the second bonding pad PD_L2.

The first and second test pads TPD_L1 and TPD_L2 may be electrically connected to each other, and may be electrically connected to the test circuit TCKT. When a test voltage VFC is applied to the first test pad TPD_L1, the test circuit TCKT may receive a test signal TS through the first and second test pads TPD_L1 and TPD_L2, may generate a test result signal TRS based on the test signal TS, and may compensate for an operation of the peripheral circuit PCKT based on the test result signal TRS. The test result signal TRS may represent or indicate a misalignment between the first and second bonding pads PD_L1 and PD_L2 (e.g., may represent or indicate a misalignment between the first and second test pads TPD_L1 and TPD_L2 or represent or indicate whether a misalignment between the first and second test pads TPD_L1 and TPD_L2 occurred).

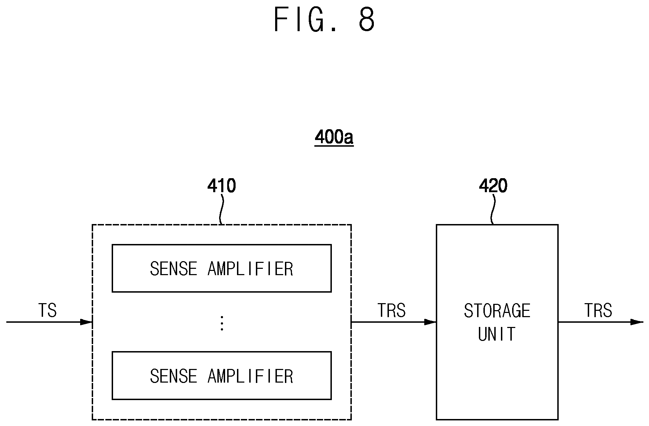

Detailed configurations and operations of the test circuit TCKT will be described with reference to FIGS. 8 through 14.

In some implementations, the first semiconductor layer L1 may be manufactured by forming the memory cell array MCA, the first bonding pad PD_L1, the first test pad TPD_L1, the first contact CT_L1 and the first insulating layer IL1 in and/or on the first substrate SUB1, the second semiconductor layer L2 may be manufactured by forming the peripheral circuit PCKT, the second bonding pad PD_L2, the second test pad TPD_L2, the test circuit TCKT, the second contact CT_L2 and the second insulating layer IL2 in and/or on the second substrate SUB2, the first semiconductor layer L1 may be turned over, and the bonding pads PD_L1 and PD_L2 and the test pads TPD_L1 and TPD_L2 may be connected using the bonding scheme. As a result, the first and second semiconductor layers L1 and L2 may be electrically connected in the third direction D3.

Although FIGS. 1 and 2 illustrate an example where the semiconductor layers L1 and L2 include a pair of the bonding pads PD_L1 and PD_L2 and a pair of the test pads TPD_L1 and TPD_L2, implementations are not limited thereto, and the number of bonding pads and the number of test pads included in the semiconductor layers L1 and L2 may be variously determined.

The memory device 10 may have or adopt a structure in which the peripheral circuit PCKT and the memory cell array MCA are stacked, e.g., a cell over periphery (COP) structure in which the peripheral circuit PCKT is formed below and then the memory cell array MCA is stacked on the peripheral circuit PCKT. Accordingly, the memory device 10 may have a relatively small size.

In addition, the memory device 10 may further includes the test pads TPD_L1 and TPD_L2 formed separately, independently and/or individually from the bonding pads PD_L1 and PD_L2, and may further include the test circuit TCKT connected to the test pads TPD_L1 and TPD_L2. It may be determined, using the test pads TPD_L1 and TPD_L2 and the test circuit TCKT, whether the misalignment between the bonding pads PD_L1 and PD_L2 occurred, and appropriate feedback operations such as screening, repairing and adjusting operation conditions may be performed depending on the degree of the misalignment. Accordingly, the defects in the memory device 10 may be relatively easily detected, and the performance degradation of the memory device 10 may be effectively prevented.

However, implementations are not limited thereto, and the memory device 10 may have or adopt a bonding vertical NAND (BVNAND) structure in which the memory cell array MCA includes vertical flash memory cells (e.g., vertical NAND cells) and the peripheral circuit PCKT and the memory cell array MCA are disposed or arranged in the third direction D3.

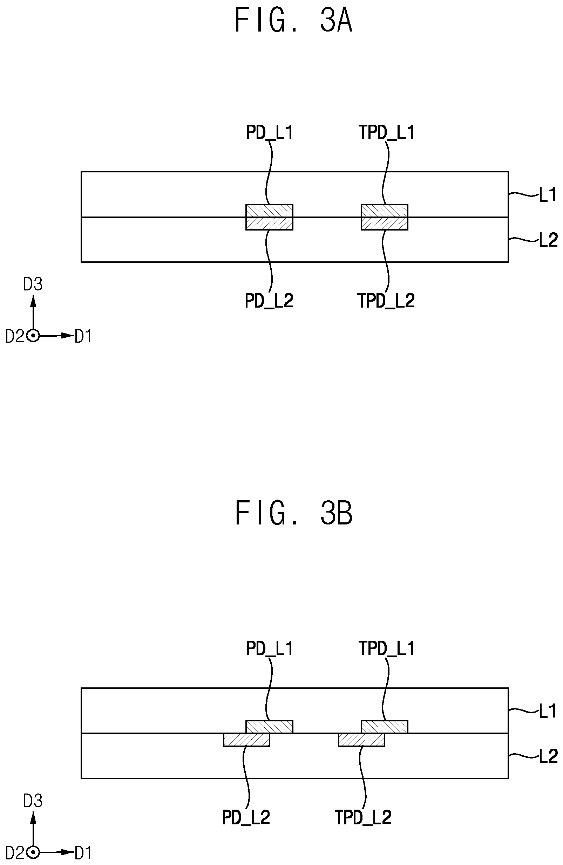

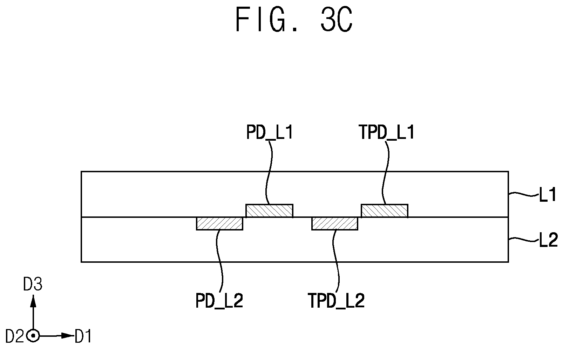

FIGS. 3A, 3B, and 3C are diagrams for describing an example of a memory device.

Referring to FIGS. 3A, 3B, and 3C, various situations that may occur when the first semiconductor layer L1 and the second semiconductor layer L2 are connected by the bonding scheme are illustrated.

FIG. 3A illustrates an example where the misalignment between the first and second bonding pads PD_L1 and PD_L2 does not occur. In other words, the first and second bonding pads PD_L1 and PD_L2 are fully aligned.

For example, the bonding pads PD_L1 and PD_L2 may have the same shape and the same size, and an area (or a length) over which the bonding pads PD_L1 and PD_L2 overlap may be larger than a first area (or a first length) on a plane or in a plan view. For example, a resistance between the bonding pads PD_L1 and PD_L2 may be less than a first resistance. For example, the test signal TS may have a relatively high voltage level. For example, as illustrated in FIG. 3A, when the bonding pads PD_L1 and PD_L2 completely overlap, the resistance between the bonding pads PD_L1 and PD_L2 may be about 0Ω, and the test signal TS may have a voltage level substantially the same as that of the test voltage VFC.

For example, the test pads TPD_L1 and TPD_L2 may also have the same shape and the same size as the bonding pads PD_L1 and PD_L2, and a distance between the first bonding pad PD_L1 and the first test pad TPD_L1 may be substantially equal to a distance between the second bonding pad PD_L2 and the second test pad TPD_L2. In this case, if the misalignment between the bonding pads PD L1 and PD L2 does not occur, the misalignment between the test pads TPD_L1 and TPD_L2 may not occur.

FIG. 3B illustrates an example where the misalignment between the first and second bonding pads PD_L1 and PD_L2 has occurred with a first level that is a compensable level. The descriptions repeated with FIG. 3A will be omitted. A compensable level may be a level of misalignment which can be compensated for by modifying one or more parameters associated with the memory device as will be described.

For example, the area (or the length) over which the bonding pads PD_L1 and PD_L2 overlap may be smaller than or equal to the first area (or the first length) and larger than a second area (or a second length) on a plane or in a plan view. For example, the resistance between the bonding pads PD_L1 and PD_L2 may be greater than or equal to the first resistance value and less than a second resistance value. For example, as the degree of the misalignment between the bonding pads PD_L1 and PD_L2 increases, e.g., as the area (or the length) over which the bonding pads PD_L1 and PD_L2 overlap decreases, the resistance between the bonding pads PD_L1 and PD_L2 may increase. In other words, the more severe the misalignment between the bonding pads PD_L1 and PD_L2, e.g., the smaller the overlapping area (or length) of the bonding pads PD_L1 and PD_L2, the larger the resistance between the bonding pads PD_L1 and PD_L2 may be. For example, as compared with the example of FIG. 3A, the test signal TS may have a lower voltage level, and the voltage level of the test signal TS may become lower as the resistance between the bonding pads PD_L1 and PD_L2 increases.

For example, as with the bonding pads PD_L1 and PD_L2, the misalignment between the first and second test pads TPD_L1 and TPD_L2 has occurred with the first level that is a compensable level.

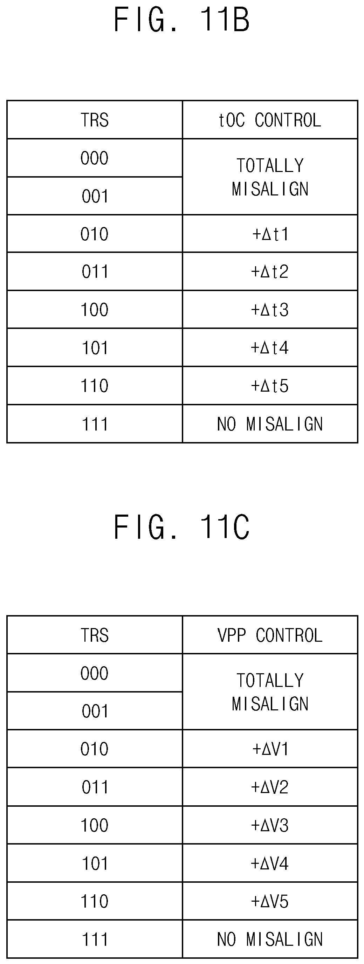

In some implementations, when the misalignment between the bonding pads PD_L1 and PD_L2 has occurred with the first level, the compensation operation may be performed by adjusting a sensing time and/or an operating voltage while specific memory cells (or a specific memory region) connected to the bonding pads PD_L1 and PD_L2 are operating, which will be described with reference to FIGS. 11B and 11C.

FIG. 3C illustrates an example where the misalignment between the first and second bonding pads PD_L1 and PD_L2 has occurred with a second level that is an uncompensable level. A compensable level is a level of misalignment which between the bonding pads PD_L1, PD_L2 which cannot be compensated for by modifying one or more parameters (e.g., sensing time and/or operating voltage) associated with the memory device as will be described. The descriptions repeated with FIGS. 3A and 3B will be omitted.

For example, the area (or the length) over which the bonding pads PD_L1 and PD_L2 overlap may be smaller than or equal to the second area (or the second length) on a plane or in a plan view. For example, the resistance between the bonding pads PD_L1 and PD_L2 may be greater than or equal to the second resistance value. For example, as compared with the example of FIG. 3B, the test signal TS may have a lower voltage level. For example, as illustrated in FIG. 3C, when the bonding pads PD_L1 and PD_L2 do not overlap at all, the resistance between the bonding pads PD_L1 and PD_L2 may be about ∞Ω, and the test signal TS may have a voltage level of about 0V.

For example, as with the bonding pads PD_L1 and PD_L2, the misalignment between the first and second test pads TPD_L1 and TPD_L2 has occurred with the second level that is a compensable level.

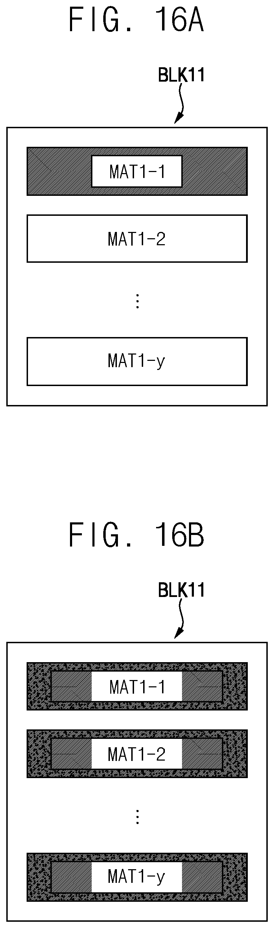

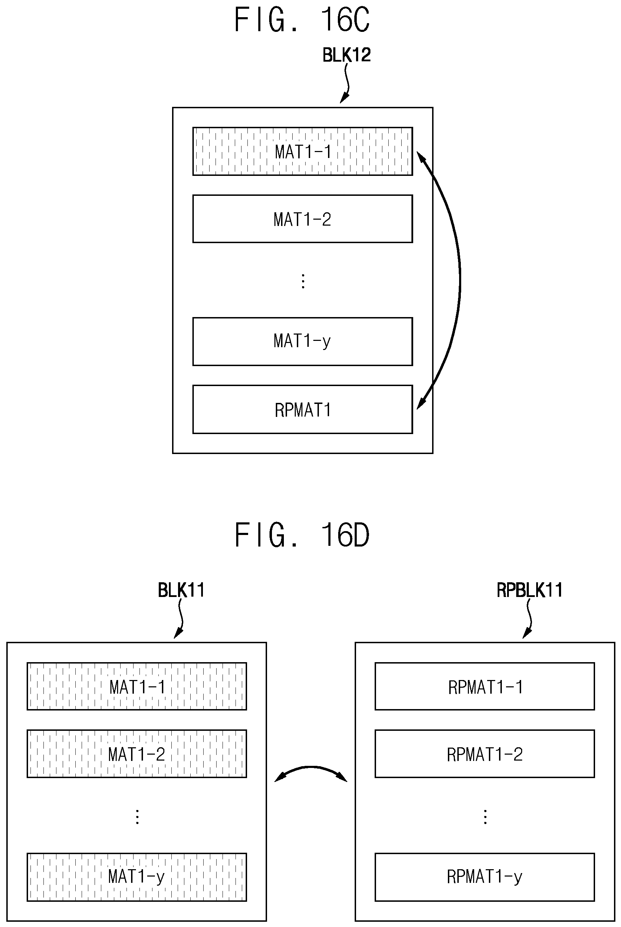

In some implementations, when the misalignment between the bonding pads PD_L1 and PD_L2 has occurred with the second level, the usage of specific memory cells (or a specific memory region) connected to the bonding pads PD_L1 and PD_L2 may be screened or blocked, and/or the specific memory cells (or the specific memory region) may be repaired to or replaced with other memory cells (or another memory region), which will be described with reference to FIGS. 16A, 16B, 16C, and 16D.

FIG. 4 is a block diagram illustrating an example of a memory device.

Referring to FIG. 4, a memory device 200 may include a peripheral circuit 201, a memory cell array 300 and a test circuit 400. The peripheral circuit 201 may include a control logic circuit 210, an address register 220, a bank control logic circuit 230, a row address multiplexer 240, a refresh counter 245, a column address latch 250, a row decoder 260, a column decoder 270, a sense amplifier unit 285, an input/output (I/O) gating circuit 290 and a data I/O buffer 295. For example, the memory device 200 may be one of various volatile memory devices such as a dynamic random access memory (DRAM).

The memory cell array 300 may include first to eighth bank arrays 310 to 380 (e.g., first to eighth bank arrays 310, 320, 330, 340, 350, 360, 370 and 380). The row decoder 260 may include first to eighth bank row decoders 260a to 260h connected respectively to the first to eighth bank arrays 310 to 380. The column decoder 270 may include first to eighth bank column decoders 270a to 270h connected respectively to the first to eighth bank arrays 310 to 380. The sense amplifier unit 285 may include first to eighth bank sense amplifiers 285a to 285h connected respectively to the first to eighth bank arrays 310 to 380.

The first to eighth bank arrays 310 to 380, the first to eighth bank row decoders 260a to 260h, the first to eighth bank column decoders 270a to 270h, and the first to eighth bank sense amplifiers 285a to 285h may form first to eighth banks. Each of the first to eighth bank arrays 310 to 380 may include a plurality of wordlines WL, a plurality of bitlines BL, and a plurality of memory cells MC that are at intersections of the wordlines WL and the bitlines BL.

Although FIG. 4 illustrates the memory device 200 including eight banks (and eight bank arrays, eight row decoders, and so on), the memory device 200 may include any number of banks; for example, one, two, four, eight, sixteen, or thirty two banks, or any number therebetween one and thirty two.

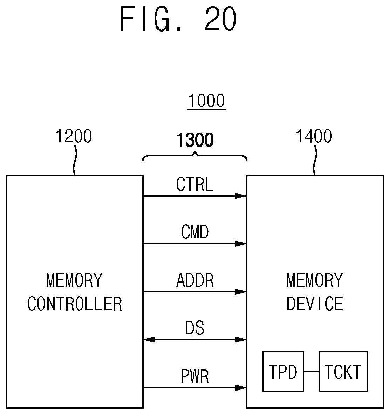

The address register 220 may receive the address ADDR including a bank address BANK_ADDR, a row address ROW_ADDR, and a column address COL_ADDR from a memory controller (e.g., a memory controller 1200 in FIG. 20). The address register 220 may provide the received bank address BANK_ADDR to the bank control logic circuit 230, may provide the received row address ROW_ADDR to the row address multiplexer 240, and may provide the received column address COL_ADDR to the column address latch 250.

The bank control logic circuit 230 may generate bank control signals in response to the bank address BANK_ADDR. One of the first to eighth bank row decoders 260a to 260h corresponding to the bank address BANK_ADDR may be activated in response to the bank control signals, and one of the first to eighth bank column decoders 270a to 270h corresponding to the bank address BANK_ADDR may be activated in response to the bank control signals.

The row address multiplexer 240 may receive the row address ROW_ADDR from the address register 220, and may receive a refresh row address REF_ADDR from the refresh counter 245. The row address multiplexer 240 may selectively output the row address ROW_ADDR or the refresh row address REF_ADDR as a row address RA. The row address RA that is output from the row address multiplexer 240 may be applied to the first to eighth bank row decoders 260a to 260h.

The activated one of the first to eighth bank row decoders 260a to 260h may decode the row address RA that is output from the row address multiplexer 240, and may activate in the corresponding bank array a wordline WL corresponding to the row address RA. For example, the activated bank row decoder may generate a wordline driving voltage, and may apply the wordline driving voltage to the wordline WL corresponding to the row address RA.

The column address latch 250 may receive the column address COL_ADDR from the address register 220, and may temporarily store the received column address COL_ADDR. In some implementations, in a burst mode, the column address latch 250 may generate column addresses that increment from the received column address COL_ADDR. The column address latch 250 may apply the temporarily stored or generated column address to the first to eighth bank column decoders 270a to 270h.

The activated one of the first to eighth bank column decoders 270a to 270h may decode the column address COL_ADDR that is output from the column address latch 250, and may control the I/O gating circuit 290 to output data corresponding to the column address COL_ADDR.

The I/O gating circuit 290 may include circuitry configured to gate input/output data. The I/O gating circuit 290 may further include read data latches configured to store data that is output from the first to eighth bank arrays 310 to 380, and may also include write control devices for writing data to the first to eighth bank arrays 310 to 380.

Data DAT read from one of the first to eighth bank arrays 310 to 380 may be sensed by a sense amplifier connected to the one bank array from which the data DAT is to be read, and may be stored in the read data latches. The data DAT stored in the read data latches may be provided to the memory controller via the data I/O buffer 295. Data DAT to be written in one of the first to eighth bank arrays 310 to 380 may be provided to the I/O gating circuit 290 via the data I/O buffer 295 from the memory controller, and the I/O gating circuit 290 may write the data DAT in the one bank array through the write drivers.

The control logic circuit 210 may control operations of the memory device 200. For example, the control logic circuit 210 may generate control signals for the memory device 200 to perform the write operation and/or the read operation. The control logic circuit 210 may include a command decoder 211 that decodes a command CMD received from the memory controller, and a mode register 212 that sets an operation mode of the memory device 200. In some implementations, operations described herein as being performed by the control logic circuit 210 may be performed by processing circuitry. For example, the command decoder 211 may generate the control signals corresponding to the command CMD by decoding a write enable signal, a row address strobe signal, a column address strobe signal, a chip selection signal, etc.

The test circuit 400 may receive the test signal TS through the first test pad TPD_L1 in the first semiconductor layer L1 including the memory cell array 300 and the second test pad TPD_L2 in the second semiconductor layer L2 including the peripheral circuit 201, may generate the test result signal TRS, which represents the misalignment between the first bonding pad PD_L1 in the first semiconductor layer L1 and the second bonding pad PD_L2 in the second semiconductor layer L2, based on the test signal TS, and may compensate the operation of the peripheral circuit 201 based on the test result signal TRS. For example, at least one of a sensing time of the memory cell array 300 by the sense amplifier unit 285 and an operating voltage supplied to the memory cell array 300 may be adjusted based on the test result signal TRS.

FIGS. 5A, 5B, and 5C are diagrams illustrating examples of a memory cell array included in a memory device of FIG. 4.

Referring to FIGS. 4 and 5A, the first bank array 310 included in the memory cell array 300 may include a plurality of wordlines WL1, WL2, ..., WLm-1, WLm (where m is a positive integer greater than or equal to two), a plurality of bitlines BL1, BL2, ..., BLn-1, BLn (where n is a positive integer greater than or equal to two that may or may not be the same as m), and a plurality of memory cells MC arranged at or near intersections between the wordlines WL1 to WLm and the bitlines BL1 to BLn. For example, each of the plurality of memory cells MC may include a DRAM cell structure. The plurality of wordlines WL1 to WLm to which the plurality of memory cells MC are connected may be referred to as rows of the first bank array 310, and the plurality of bitlines BL1 to BLn to which the plurality of memory cells MC are connected may be referred to as columns of the first bank array 310.

Referring to FIG. 5B, an i-th (where i is a positive integer) bank array BANKi included in the memory cell array 300 may include first to x-th (where x is a positive integer greater than or equal to two) blocks BLK1, BLK2, ..., BLKx. Although not illustrated in detail, each of the blocks BLK1 to BLKx may include a plurality of memory cells. For convenience, a bank array may simply be referred to as a bank.

Referring to FIG. 5C, a j-th (where j is a positive integer) block BLKj included in the memory cell array 300 may include first to y-th (where y is a positive integer greater than or equal to two) mats MAT1, MAT2, ..., MATy. Although not illustrated in detail, each of the mats MAT1 to MATy may include a plurality of memory cells. A mat may be referred to as a sub-array.

Although the memory device is described based on a DRAM, the memory device may be any volatile memory device, and/or any nonvolatile memory device, e.g., a static random access memory (SRAM), a flash memory, a phase-change random access memory (PRAM), a resistive random access memory (RRAM), a magnetic random access memory (MRAM), a ferroelectric random access memory (FRAM), or the like.

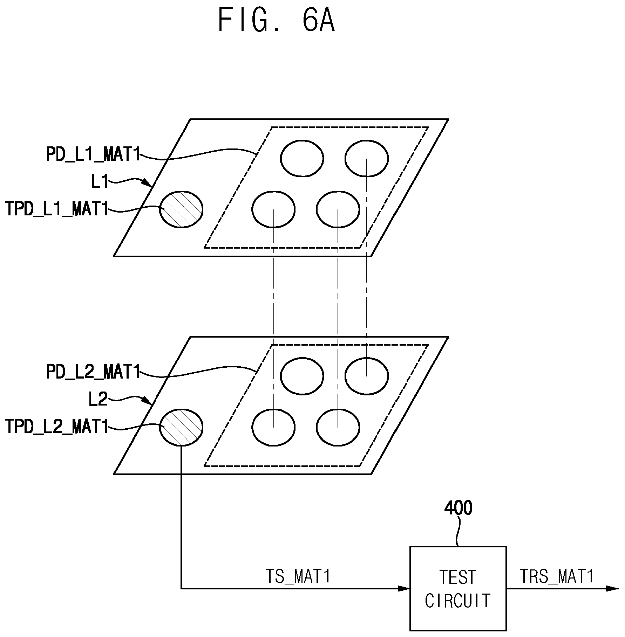

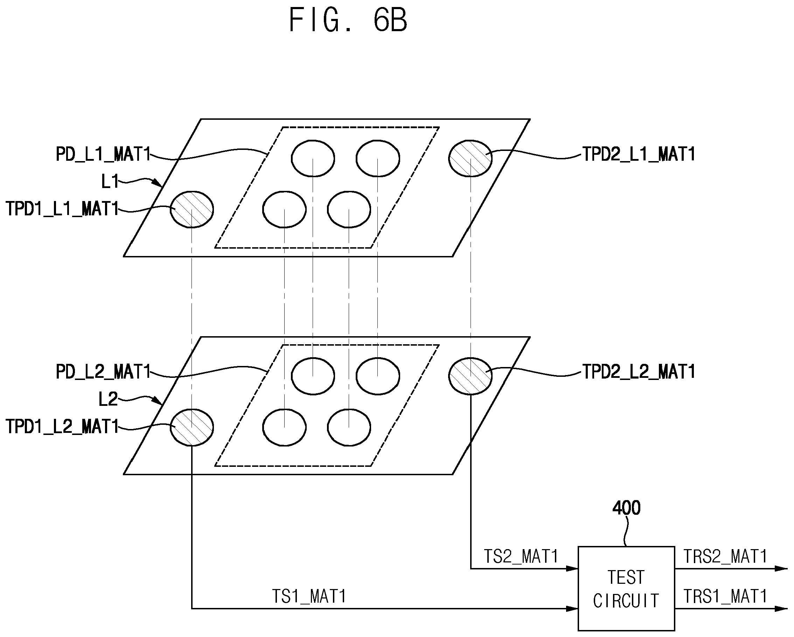

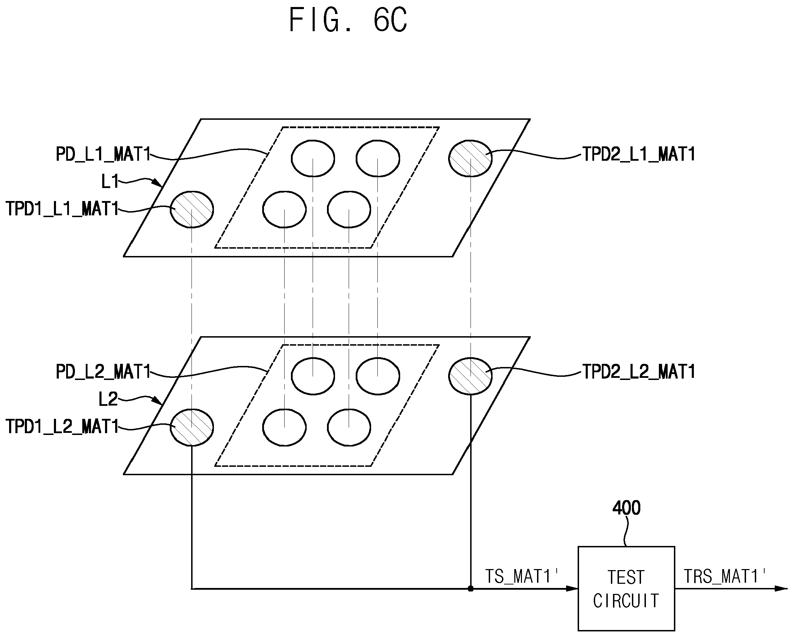

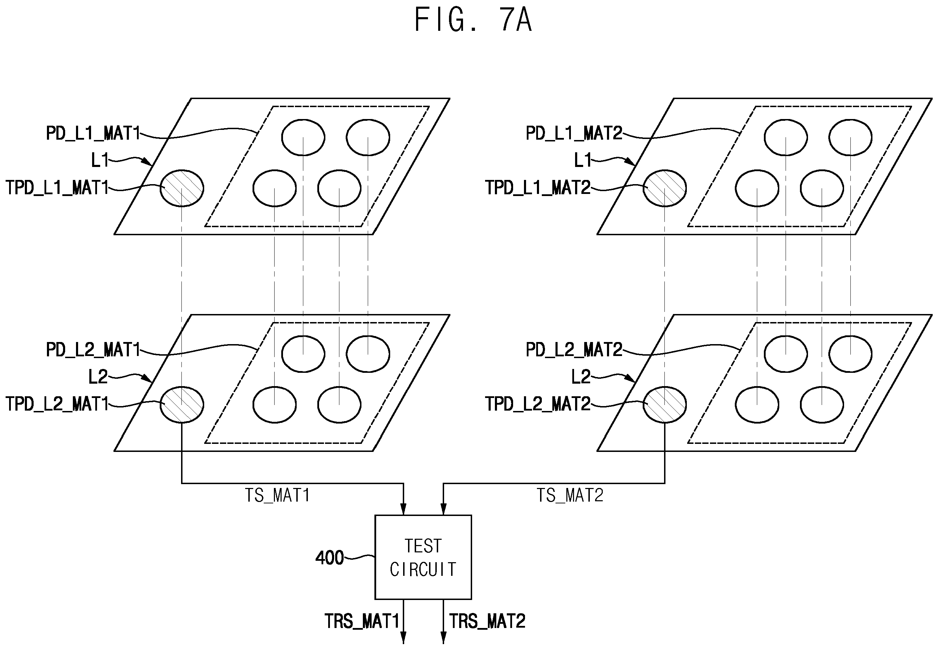

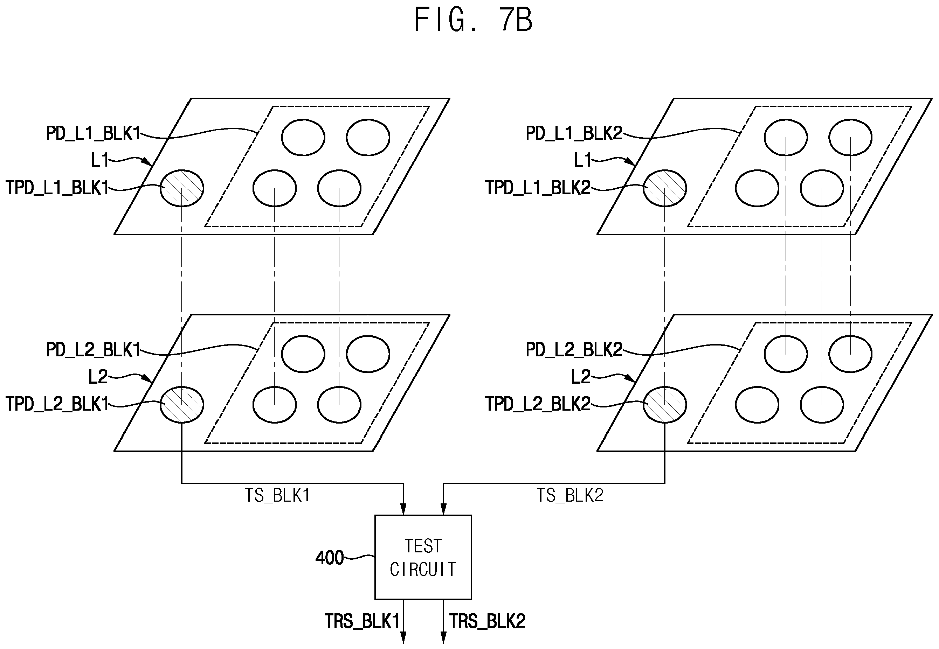

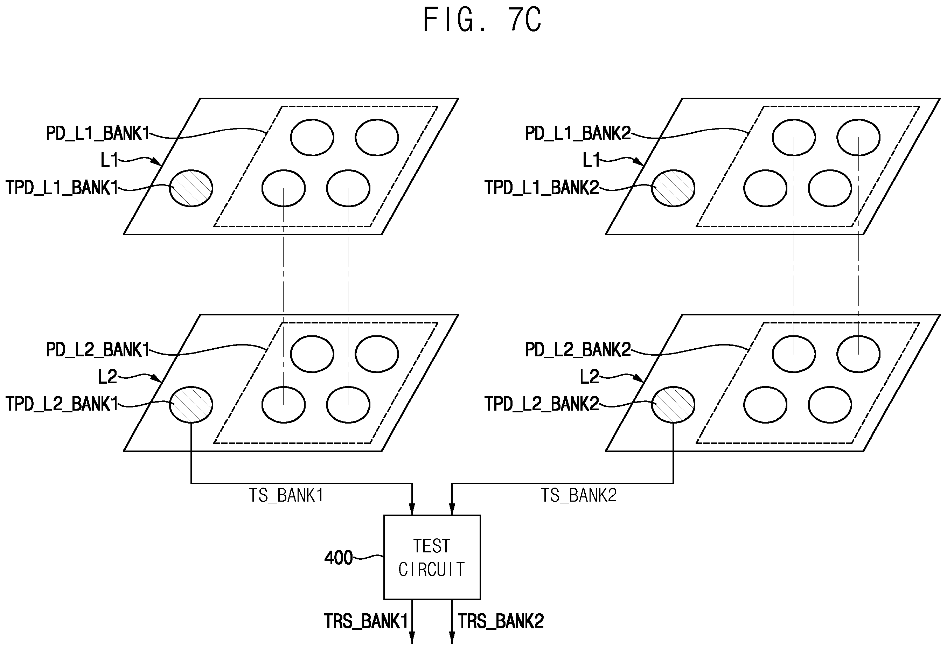

FIGS. 6A, 6B, 6C, 7A, 7B, and 7C are diagrams illustrating examples of bonding pads, test pads and a test circuit that are included in a memory device.

Referring to FIGS. 6A, 6B and 6C, configurations of the bonding pads and the test pads included in one mat and operations of the test circuit using the bonding pads and the test pads are illustrated. For convenience of illustration, components irrelevant to the pads and the test circuit are omitted.

FIG. 6A illustrates an example where one mat includes a pair of test pads.

For example, a first mat MAT1 may include bonding pads PD_L1_MAT1 formed in the first semiconductor layer L1, and bonding pads PD_L2_MAT1 formed in the second semiconductor layer L2 and connected to the bonding pads PD_L1_MAT1. For example, the first mat MAT1 may include a test pad TPD _L1_MAT1 formed in the first semiconductor layer L1, and a test pad TPD_L2_MAT1 formed in the second semiconductor layer L2 and connected to the test pad TPD _L1_MAT1.

The test circuit 400 may receive a test signal TS_MAT1 through the test pads TPD_L1_MAT1 and TPD_L2_MAT1 included in the first mat MAT1. Based on the test signal TS_MAT1, the test circuit 400 may generate and store a test result signal TRS_MAT1 that represents a misalignment between the bonding pads PD_L1_MAT1 and PD_L2_MAT1 of the first mat MAT1. Based on the test result signal TRS_MAT1, the test circuit 400 may compensate for the operation of the peripheral circuit PCKT while operating the first mat MAT1.

FIG. 6B illustrates an example where one mat includes several pairs of test pads and the test pads are connected in parallel. The descriptions repeated with FIG. 6A will be omitted.

In an example of FIG. 6B, the first mat MAT1 may include test pads TPD1_L1_MAT1 and TPD2_L1_MAT1 formed in the first semiconductor layer L1, and test pads TPD1_L2_MAT1 and TPD2_L2_MAT1 formed in the second semiconductor layer L2 and connected to the test pads TPD1_L1_MATI1 and TPD2_L1_MAT1, respectively. The test pads TPD1_L1_MAT1 and TPD1_L2_MAT1 may be connected to the test circuit 400 independently, individually or separately from the test pads TPD2_L1_MAT1 and TPD2_L2_MAT1.

The test circuit 400 may receive a test signal TS1_MAT1 through the test pads TPD1_L1_MAT1 and TPD1_L2_MAT1 of the first mat MAT1, and a test signal TS2_MAT1 through the test pads TPD2_L1_MAT1 and TPD2_L2_MAT1 of the first mat MAT1. Based on the test signals TS1_MAT1 and TS2_MAT1, the test circuit 400 may generate and store test result signals TRS1_MAT1 and TRS2_MAT1 that represents whether the misalignment between the bonding pads PD_L1_MAT1 and PD_L2_MAT1 of the first mat MAT1 has occurred. Based on the test result signals TRS1_MAT1 and TRS2_MAT1, the test circuit 400 may compensate for the operation of the peripheral circuit PCKT while operating the first mat MAT1.

FIG. 6C illustrates an example where one mat includes several pairs of test pads and the test pads are connected in series. The descriptions repeated with FIGS. 6A and 6B will be omitted.

In an example of FIG. 6C, the test pads TPD1_L1_MAT1 and TPD1_L2_MAT1 may be connected to the test circuit 400 together with the test pads TPD2_L1_MAT1 and TPD2_L2_MAT1.

The test circuit 400 may receive two test signals through the test pads TPD1_L1_MAT1, TPD1_L2_MAT1 of the first mat MAT1 and test pads TPD2_L1_MAT1, TPD2_L2_MAT1 of the first mat MAT1. Since the test pads TPD1_L1_MAT1, TPD1_L2_MAT1, TPD2_L1_MAT1 and TPD2_L2_MAT1 are collectively connected to the test circuit 400, the two test signals may be provided as one integrated test signal TS _MAT1'. Based on the test signal TS_MAT1', the test circuit 400 may generate and store a test result signal TRS_MAT1' that represents whether the misalignment between the bonding pads PD_L1_MAT1 and PD_L2_MAT1 of the first mat MAT1 has occurred. Based on the test result signal TRS_MAT1', the test circuit 400 may compensate for the operation of the peripheral circuit PCKT while operating the first mat MAT1.

Although FIGS. 6B and 6C illustrate examples where one mat includes two pairs of test pads, implementations are not limited thereto. For example, an arbitrary number of test pads may be included in one mat.

FIG. 7A illustrates an example where each of different mats includes a pair of test pads. The descriptions repeated with FIG. 6A will be omitted.

For example, a second mat MAT2 may include bonding pads PD_L1_MAT2 and PD_L2_MAT2 formed in the first and second semiconductor layers L1 and L2 and connected to each other. For example, the second mat MAT2 may include test pads TPD_L1_MAT2 and TPD_L2_MAT2 formed in the first and second semiconductor layers L1 and L2 and connected to each other.

The test circuit 400 may receive a test signal TS_MAT2 through the test pads TPD_L1_MAT2 and TPD_L2_MAT2 of the second mat MAT2. Based on the test signal TS _MAT2, the test circuit 400 may generate and store a test result signal TRS_MAT2 that represents a misalignment between the bonding pads PD_L1_MAT2 and PD_L2_MAT2 of the second mat MAT2. Based on the test result signal TRS _MAT2, the test circuit 400 may compensate for the operation of the peripheral circuit PCKT while operating the second mat MAT2.

FIG. 7B illustrates an example where each of different blocks includes a pair of test pads.

For example, a first block BLK1 may include bonding pads PD_L1_BLK1 and PD_L2_BLK1 formed in the first and second semiconductor layers L1 and L2 and connected to each other, and test pads TPD_L1_BLK1 and TPD_L2_BLK1 formed in the first and second semiconductor layers L1 and L2 and connected to each other. For example, a second block BLK2 may include bonding pads PD_L1_BLK2 and PD_L2_BLK2 formed in the first and second semiconductor layers L1 and L2 and connected to each other, and test pads TPD_L1_BLK2 and TPD_L2_BLK2 formed in the first and second semiconductor layers L1 and L2 and connected to each other.

The test circuit 400 may receive a test signal TS_BLK1 through the test pads TPD_L1_BLK1 and TPD_L2_BLK1 of the first block BLK1. Based on the test signal TS_BLK1, the test circuit 400 may generate and store a test result signal TRS_BLK1 that represents a misalignment between the bonding pads PD_L1_BLK1 and PD_L2_BLK1 of the first block BLK1. Based on the test result signal TRS _BLK1, the test circuit 400 may compensate for the operation of the peripheral circuit PCKT while operating the first block BLK1. In addition, the test circuit 400 may receive a test signal TS_BLK2 through the test pads TPD_L1_BLK2 and TPD_L2_BLK2 of the second block BLK2. Based on the test signal TS _BLK2, the test circuit 400 may generate and store a test result signal TRS _BLK2 that represents a misalignment between the bonding pads PD_L1_BLK2 and PD_L2_BLK2 of the second block BLK2. Based on the test result signal TRS_BLK2, the test circuit 400 may compensate for the operation of the peripheral circuit PCKT while operating the second block BLK2.

FIG. 7C illustrates an example where each of different banks includes a pair of test pads.

For example, a first bank BANK1 (i.e., first bank array 310) may include bonding pads PD_L1_BANK1 and PD_L2_BANK1 formed in the first and second semiconductor layers L1 and L2 and connected to each other, and test pads TPD_L1_BANK1 and TPD_L2_BANK1 formed in the first and second semiconductor layers L1 and L2 and connected to each other. For example, a second bank BANK2 (i.e., second bank array 320) may include bonding pads PD_L1_BANK2 and PD_L2_BANK2 formed in the first and second semiconductor layers L1 and L2 and connected to each other, and test pads TPD_L1_BANK2 and TPD_L2_BANK2 formed in the first and second semiconductor layers L1 and L2 and connected to each other.

The test circuit 400 may receive a test signal TS_BANK1 through the test pads TPD_L1_BANK1 and TPD_L2_BANK1 of the first bank BANK1. Based on the test signal TS_BANK1, the test circuit 400 may generate and store a test result signal TRS_BANK1 that represents a misalignment between the bonding pads PD_L1_BANK1 and PD_L2_BANK1 of the first bank BANK1. Based on the test result signal TRS_BANK1, the test circuit 400 may compensate for the operation of the peripheral circuit PCKT while operating the first bank BANK1. In addition, the test circuit 400 may receive a test signal TS_BANK2 through the test pads TPD_L1_BANK2 and TPD_L2_BANK2 of the second bank BANK2. Based on the test signal TS _BANK2, the test circuit 400 may generate and store a test result signal TRS_BANK2 that represents a misalignment between the bonding pads PD_L1_BANK2 and PD_L2_BANK2 of the second bank BANK2. Based on the test result signal TRS _BANK2, the test circuit 400 may compensate for the operation of the peripheral circuit PCKT while operating the second bank BANK2.

Although FIGS. 7A, 7B and 7C illustrate examples where one mat, one block and one bank include a pair of test pads, implementations are not limited thereto. For example, as described with reference to FIGS. 6B and 6C, several pairs of test pads that are connected in parallel or in series may be included in one mat, one block and one bank.

In the memory device, a pair of test pads or multiple pairs of test pads may be provided for each mat, for each block and/or for each bank. Based on the test pads, the bonding defects (e.g., the misalignment) may be detected for each mat, for each block and/or for each bank, and the feedback operations (e.g., screening, repairing and operation condition adjusting, or the like) may be performed for each mat, for each block and/or for each bank when the defects are detected.

FIG. 8 is a block diagram illustrating an example of a test circuit included in a memory device.

Referring to FIG. 8, a test circuit 400a may include a plurality of sense amplifiers 410 and a storage unit 420.

The plurality of sense amplifiers 410 may generate the test result signal TRS based on the test signal TS. The storage unit 420 may store and output the test result signal TRS.

For example, each of the plurality of sense amplifiers 410 may compare the test signal TS with a reference voltage for a predetermined sensing time, and may generate a part or portion of the test result signal TRS as a result of the comparison. For example, the storage unit 420 may include components each of which stores the part of the test result signal TRS. For example, the test signal TS may be one of the test signals TS _MAT1, TS1_MAT1, TS2_MAT1, TS_MAT1', TS _MAT2, TS_BLK1, TS_BLK2, TS_BANK1 and TS_BANK2 described with reference to FIGS. 6A, 6B, 6C, 7A, 7B, and 7C, and the test result signal TRS may be one of the test result signals TRS _MAT1, TRS1 _MAT1, TRS2_MAT1, TRS _MAT1', TRS_MAT2, TRS_BLK1, TRS_BLK2, TRS_BANK1 and TRS_BANK2 described with reference to FIGS. 6A, 6B, 6C, 7A, 7B, and 7C.

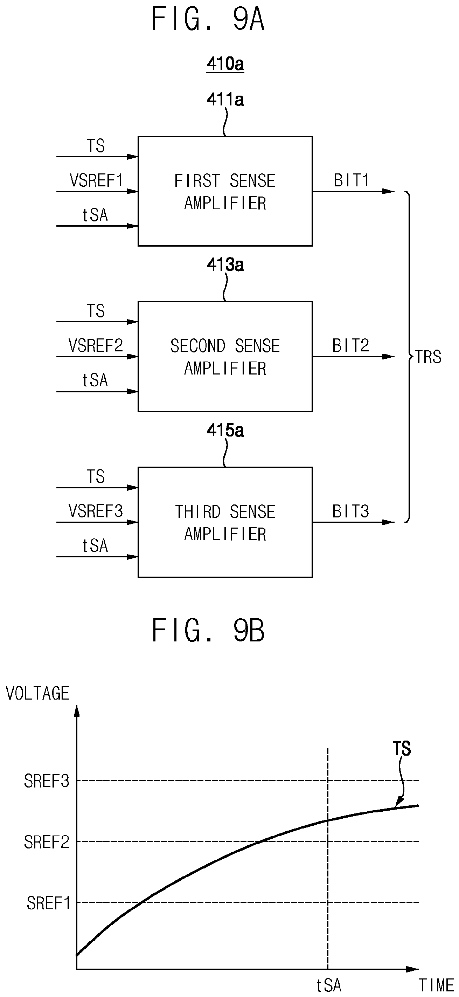

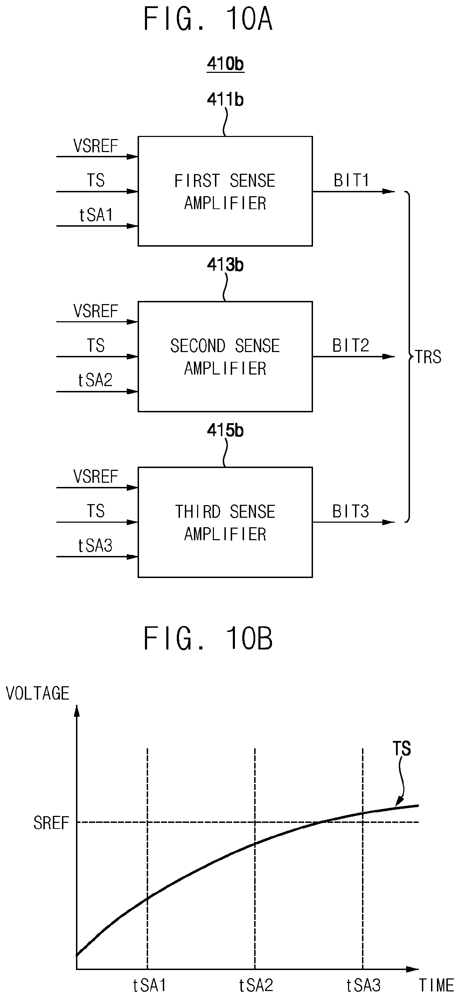

FIGS. 9A, 9B, 10A, and 10B are diagrams illustrating examples of a plurality of sense amplifiers included in a test circuit of FIG. 8.

Referring to FIGS. 9A and 9B, a plurality of sense amplifiers 410a may include a first sense amplifier 411a, a second sense amplifier 413a and a third sense amplifier 415a.

The plurality of sense amplifiers 410a may operate based on different reference voltages VSREF1, VSREF2 and VSREF3, and based on the same sensing time tSA.

For example, the first sense amplifier 411a may generate a first bit BIT1 of the test result signal TRS based on the test signal TS, the first reference voltage VSREF1 having a first voltage level SREF1 and the sensing time tSA. The second sense amplifier 413a may generate a second bit BIT2 of the test result signal TRS based on the test signal TS, the second reference voltage VSREF2 having a second voltage level SREF2 higher than the first voltage level SREF1, and the sensing time tSA. The third sense amplifier 415a may generate a third bit BIT3 of the test result signal TRS based on the test signal TS, the third reference voltage VSREF3 having a third voltage level SREF3 higher than the second voltage level SREF2, and the sensing time tSA. For example, the first bit BIT1, the second bit BIT2 and the third bit BIT3 may be a least significant bit (LSB), a central significant bit (CSB) and a most significant bit (MSB) of the test result signal TRS, respectively.

In an example of FIG. 9B, at the sensing time tSA, the voltage level of the test signal TS may be higher than the first voltage level SREF1 of the first reference voltage VSREF1, may be higher than the second voltage level SREF2 of the second reference voltage VSREF2, and may be lower than the third voltage level SREF3 of the third reference voltage VSREF3. Therefore, the first sense amplifier 411a may generate the first bit BIT1 having a first logic level (e.g., '1') by comparing the first reference voltage VSREF1 with the test signal TS, the second sense amplifier 413a may generate the second bit BIT2 having the first logic level (e.g., '1') by comparing the second reference voltage VSREF2 with the test signal TS, and the third sense amplifier 415a may generate the third bit BIT3 having a second logic level (e.g., '0') by comparing the third reference voltage VSREF3 with the test signal TS. For example, the test result signal TRS having a value of '011' may be generated. In addition, as described with reference to FIGS. 3A, 3B, and 3C, the voltage level of the test signal TS may vary depending on the degree of the misalignment between the bonding pads PD_L1 and PD_L2. For example, as the degree of the misalignment between the bonding pads PD_L1 and PD_L2 increases, the voltage level of the test signal TS may decrease (e.g., the more severe the misalignment between the bonding pads PD_L1 and PD_L2, the lower the voltage level of the test signal TS may be).

Referring to FIGS. 10A and 10B, a plurality of sense amplifiers 410b may include a first sense amplifier 411b, a second sense amplifier 413b and a third sense amplifier 415b.

The plurality of sense amplifiers 410b may operate based on different sensing times tSA1, tSA2 and tSA3, and based on the same reference voltage VSREF.

For example, the first sense amplifier 411b may generate a first bit BIT1 of the test result signal TRS based on the reference voltage VSREF having a voltage level SREF, the test signal TS and the first sensing time tSA1. The second sense amplifier 413b may generate a second bit BIT2 of the test result signal TRS based on the reference voltage VSREF, the test signal TS and the second sensing time tSA2 longer than the first sensing time tSA1. The third sense amplifier 415b may generate a third bit BIT3 of the test result signal TRS based on the reference voltage VSREF, the test signal TS and the third sensing time tSA3 longer than the second sensing time tSA2.

In an example of FIG. 10B, the voltage level of the test signal TS may be lower than the voltage level SREF of the reference voltage VSREF at the first sensing time tSA1, the voltage level of the test signal TS may be lower than the voltage level SREF of the reference voltage VSREF at the second sensing time tSA2, and the voltage level of the test signal TS may be higher than the voltage level SREF of the reference voltage VSREF at the third sensing time tSA3. Therefore, the first sense amplifier 411b may generate the first bit BIT1 having the first logic level (e.g., '1') by comparing the reference voltage VSREF with the test signal TS, the second sense amplifier 413b may generate the second bit BIT2 having the first logic level (e.g., '1') by comparing the reference voltage VSREF with the test signal TS, and the third sense amplifier 415b may generate the third bit BIT3 having a second logic level (e.g., '0') by comparing the reference voltage VSREF with the test signal TS. For example, the test result signal TRS having a value of '011' may be generated. In addition, as described with reference to FIGS. 3A, 3B, and 3C, the voltage level of the test signal TS may vary depending on the degree of the misalignment between the bonding pads PD_L1 and PD_L2. For example, as the degree of the misalignment between the bonding pads PD_L1 and PD_L2 increases, the voltage level of the test signal TS may decrease.

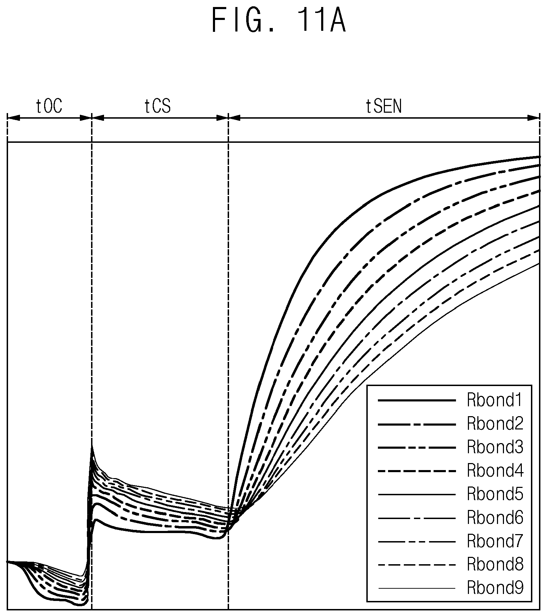

FIGS. 11A, 11B, and 11C are diagrams for describing an example of an operation of a memory device using a test circuit of FIG. 8.

Referring to FIGS. 4 and 11A, an example of changes in a voltage level of a bitline depending on an operation (e.g., sensing operation) of a bitline sense amplifier included in the sense amplifier unit 285 of the memory device 200 is illustrated. For example, FIG. 11A illustrates changes in the voltage level of the bitline depending on resistances Rbond1, Rbond2, Rbond3, Rbond4, Rbond5, Rbond6, Rbond7, Rbond8 and Rbond9 between the bonding pads.

For example, an offset cancellation may be performed during a first time tOC, a charge sharing between the memory cell and the bitline may be performed during a second time tCS, and data stored in the memory cell may be actually sensed during a third time tSEN. The overall times tOC, tCS and tSEN during which the sensing operation is performed may be defined as a sensing time.

With respect to the resistances Rbond1 to Rbond9 between the bonding pads, the resistance Rbond1 may have the smallest value, the resistances Rbond2 to Rbond8 may have values that gradually increase, and the resistance Rbond9 may have the largest value. As the resistance between the bonding pads increases, e.g., as the degree of the misalignment between the bonding pads becomes more severe, the performance of the sensing operation may be degraded or deteriorated.

Referring to FIGS. 3A, 3B, 3C, 11B and 11C, examples where the degree of the misalignment between the bonding pads is determined depending on the value of the test result signal TRS that is obtained based on the voltage level of the test signal TS are illustrated.

For example, when the test signal TS has a relatively high voltage level (e.g., the voltage level substantially the same as the test voltage VFC) and the value of the test result signal TRS is obtained as '111', it may be determined that the misalignment between the bonding pads PD_L1 and PD_L2 does not occur, as illustrated in FIG. 3A. In this case, a mat, block and/or bank including the bonding pads PD_L1 and PD_L2 may normally operate without an additional feedback operation.

For example, when the test signal TS has a lower voltage level as compared with the example of FIG. 3A and the value of the test result signal TRS is obtained as one of '110', '101', '100', '011' and '010', it may be determined that the misalignment between the bonding pads PD_L1 and PD_L2 has occurred with the first level that is a compensable level, as illustrated in FIG. 3B. In this case, when or while operating the mat, block and/or bank including the bonding pads PD_L1 and PD_L2, the operation of the peripheral circuit PCKT may be controlled such that the sensing time is adjusted as illustrated in FIG. 11B or the operating voltage is adjusted as illustrated in FIG. 11C. For example, the operation of adjusting the sensing time may represent an operation of increasing the first time tOC for performing the offset cancellation described with reference to FIG. 11A. For example, the operation of adjusting the operating voltage may represent an operation of increasing a high level of a voltage supplied to a wordline (e.g., an enable level of a VPP voltage).

For example, when the test signal TS has a lower voltage level as compared with the example of FIG. 3B and the value of the test result signal TRS is obtained as one of '001' and '000', it may be determined that the misalignment between the bonding pads PD_L1 and PD_L2 has occurred with the second level that is an uncompensable level. In this case, as will be described with reference to FIGS. 16A, 16B, 16C, and 16D, the operation of the peripheral circuit PCKT may be controlled such that the usage of the mat, block and/or bank including the bonding pads PD_L1 and PD_L2 is screened or the mat, block and/or bank including the bonding pads PD_L1 and PD_L2 is repaired.

In some implementations, when it is determined that the misalignment between the bonding pads PD_L1 and PD_L2 has occurred with the first level that is a compensable level, it may be determined that there is almost no misalignment as the voltage level of the test signal TS is higher and the value of the test result signal TRS is larger, and it may be determined that the misalignment is more severe as the voltage level of the test signal TS is lower and the value of the test result signal TRS is smaller. For example, when the value of the test result signal TRS is '110', it may be determined that a weak misalignment has occurred. For example, when the value of the test result signal TRS is '010', it may be determined that a hard or severe misalignment has occurred.

In some implementations, when it is determined that the misalignment between the bonding pads PD_L1 and PD_L2 has occurred with the first level that is a compensable level, and when the sensing time (e.g., the first time tOC) is adjusted as illustrated in FIG. 11B, the sensing time may increase as the degree of the misalignment between the bonding pads increases (e.g., the more severe the misalignment, the longer the sensing time may be). For example, when the value of the test result signal TRS is '110', '101', '100', '011' and '010', the sensing time (e.g., the first time tOC) may increase by Δt5, Δt4, Δt3, Δt2 and Δt1, respectively. For example, when the value of the test result signal TRS is '010', the increment Δt1 in the sensing time may be the largest value. For example, when the value of the test result signal TRS is '110', the increment Δt5 in the sensing time may be the smallest value. For example, Δt1>Δt2>Δt3>Δt4>Δt5.

In some implementations, when it is determined that the misalignment between the bonding pads PD_L1 and PD_L2 has occurred with the first level that is a compensable level, and when the voltage level of the operating voltage (e.g., the enable level of the VPP voltage) is adjusted as illustrated in FIG. 11C, the voltage level of the operating voltage may increase as the degree of the misalignment between the bonding pads increases (e.g., the more severe the misalignment, the higher the voltage level of the operating voltage may be). For example, when the value of the test result signal TRS is '110', '101', '100', '011' and '010', the voltage level of the operating voltage (e.g., the enable level of the VPP voltage) may increase by ΔV5, ΔV4, ΔV3, ΔV2 and ΔV1, respectively. For example, when the value of the test result signal TRS is '010', the level increment ΔV1 in the operating voltage may be the largest value. For example, when the value of the test result signal TRS is '110', the level increment ΔV5 in the operating voltage may be the smallest value. For example, ΔV1>ΔV2>ΔV3>ΔV4>ΔV5.

In some implementations, the compensation operations of FIGS. 11B and 11C may be performed simultaneously and/or concurrently.

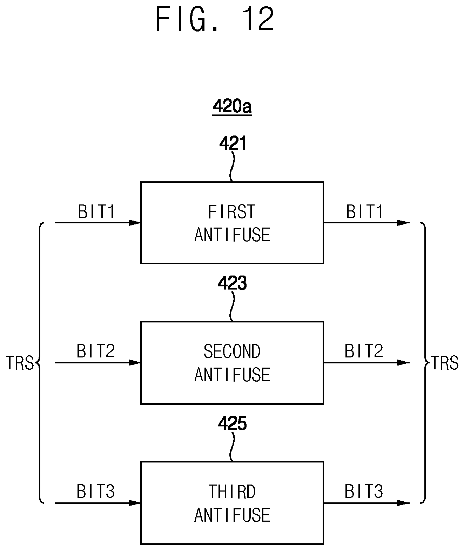

FIG. 12 is a block diagram illustrating an example of a storage unit included in a test circuit of FIG. 8.

Referring to FIG. 12, a storage unit 420a may include a first antifuse 421, a second antifuse 423 and a third antifuse 425.

The first antifuse 421 may store and output the first bit BIT) of the test result signal TRS. The second antifuse 423 may store and output the second bit BIT2 of the test result signal TRS. The third antifuse 425 may store and output the third bit BIT3 of the test result signal TRS. For example, an antifuse may be implemented in a structure where dielectric material is inserted between two conductive electrodes, and the antifuse may be programmed (e.g., electrically shorted) by applying a program voltage (e.g., a relatively high voltage) through the two conductive electrodes of the antifuse (e.g., both ends of the antifuse) for sufficient time such that the dielectric material between the two conductive electrodes is damaged destroyed or ruptured. For example, when each bit of the test result signal TRS has the first logic level (e.g., '1'), the corresponding antifuse may be programmed.

However, implementations are not limited thereto, and the storage unit may include at least one of various components for storing bits of the test result signal TRS.

Although FIGS. 9A, 9B, 10A, 10B, 11B, 11C, and 12 illustrate examples where the test result signal TRS that is a 3-bit digital code is generated and stored using three sense amplifiers and three antifuses, implementations are not limited thereto.

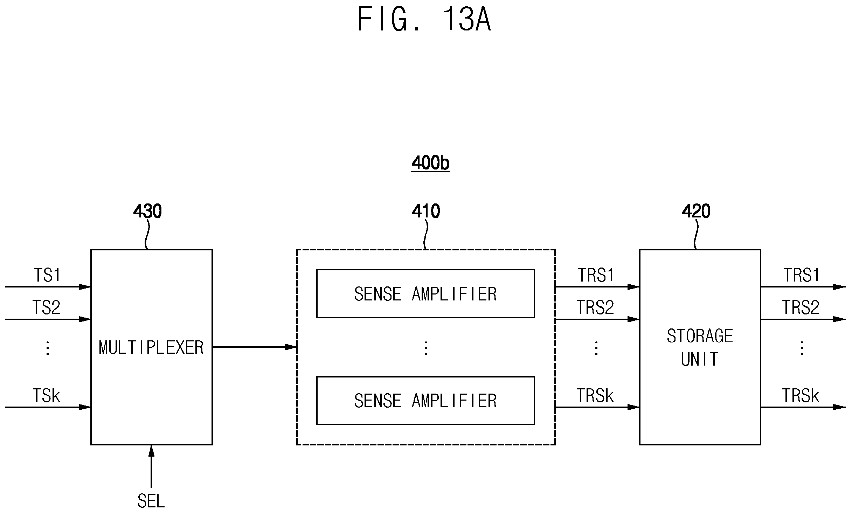

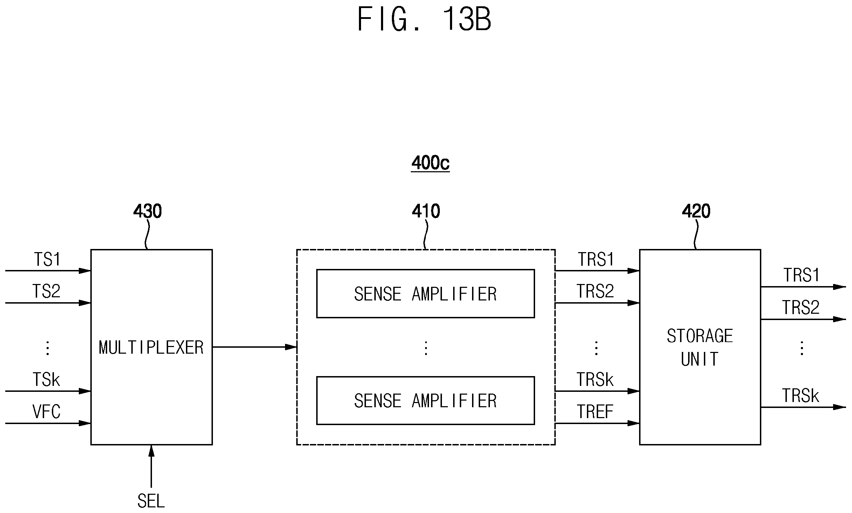

FIGS. 13A and 13B are block diagrams illustrating examples of a test circuit included in a memory device.

Referring to FIG. 13A, a test circuit 400b may include a plurality of sense amplifiers 410, a storage unit 420 and a multiplexer 430.

The test circuit 400b may be substantially the same as the test circuit 400 of FIG. 8, except that the test circuit 400b further includes the multiplexer 430.

The multiplexer 430 may select and output one of a plurality of test signals TS1, TS2, ..., TSk (where k is a positive integer greater than or equal to two) based on a selection signal SEL. The plurality of sense amplifiers 410 may generate a plurality of test result signals TRS1, TRS2, ..., TRSk based on the plurality of test signals TS1 to TSk. The storage unit 420 may store and output the plurality of test result signals TRS1 to TRSk. For example, each of the plurality of test signals TS1 to TSk may be one of the test signals TS_MAT1, TS1_MAT1, TS2_MAT1, TS _MAT1', TS _MAT2, TS_BLK1, TS_BLK2, TS_BANK1 and TS_BANK2 described with reference to FIGS. 6A, 6B, 6C, 7A, 7B, and 7C, and each of the plurality of test result signals TRS1 to TRSk may be one of the test result signals TRS _MAT1, TRS1_MAT1, TRS2_MAT1, TRS _MAT1', TRS _MAT2, TRS_BLK1, TRS _BLK2, TRS_BANK1 and TRS_BANK2 described with reference to FIGS. 6A, 6B, 6C, 7A, 7B, and 7C. For example, the selection signal SEL may be a test mode register set (TMRS) signal, and the test operation may be performed for each mat, block and bank using the TMRS signal.

Referring to FIG. 13B, the test circuit 400c may include a plurality of sense amplifiers 410, a storage unit 420 and a multiplexer 430.

The test circuit 400c may be substantially the same as the test circuit 400 of FIG. 8, except that the test circuit 400c further includes the multiplexer 430.

The multiplexer 430 may select and output one of a plurality of test signals TS1, TS2, ..., TSk and a test voltage VFC based on a selection signal SEL. The plurality of sense amplifiers 410 may generate a plurality of test result signals TRS1, TRS2, ..., TRSk and a reference test signal TREF based on the plurality of test signals TS1 to TSk and the test voltage VFC. The test voltage VFC and the reference test signal (TREF) may be used as reference signals.

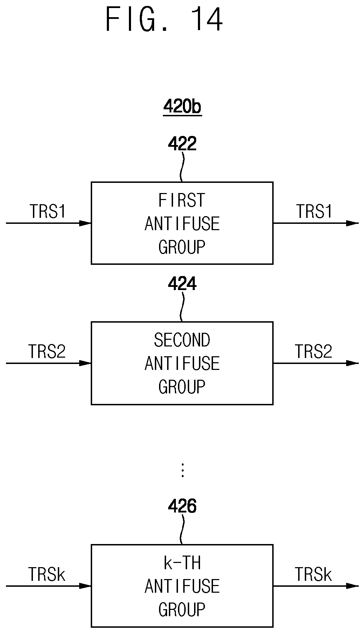

FIG. 14 is a block diagram illustrating an example of a storage unit included in test circuits of FIGS. 13A and 13B.

Referring to FIG. 14, a storage unit 420b may include a first antifuse group 422, a second antifuse group 424 and a k-th antifuse group 426.

The first antifuse group 422, the second antifuse group 424 and the k-th antifuse group 426 may store the first test result signal TRS1, the second test result signal TRS2 and the k-th test result signal TRSk, respectively. For example, each of the antifuse groups 422, 424 and 426 may include antifuses as described with reference to FIG. 12.

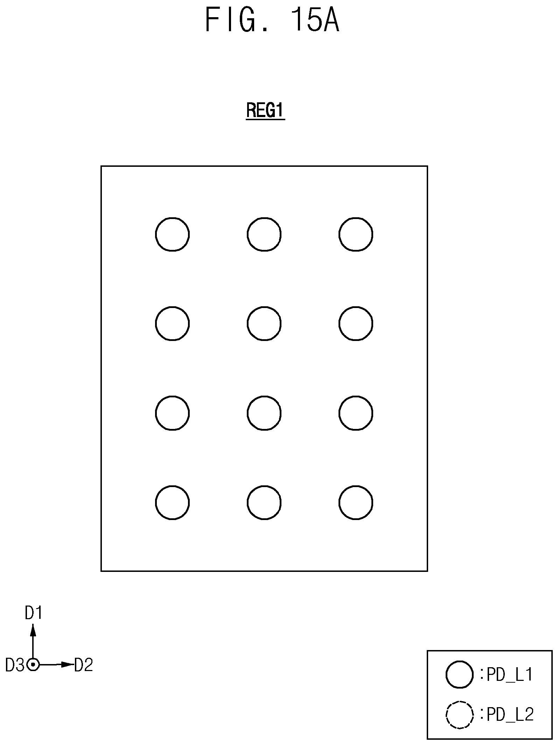

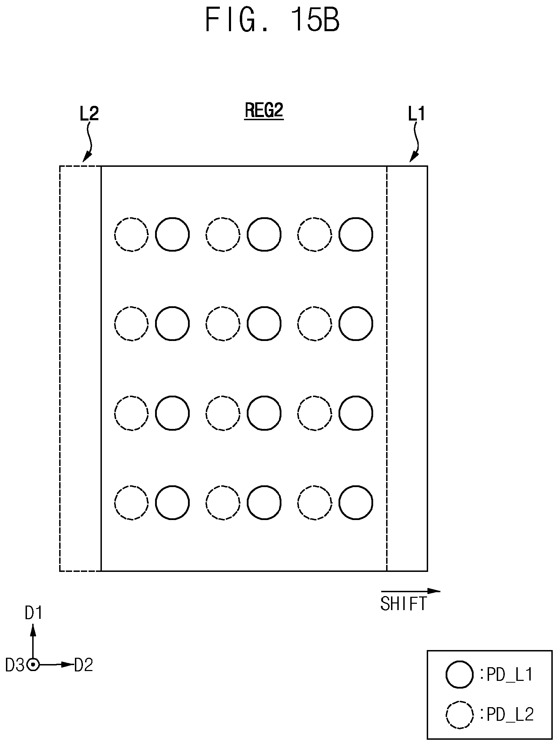

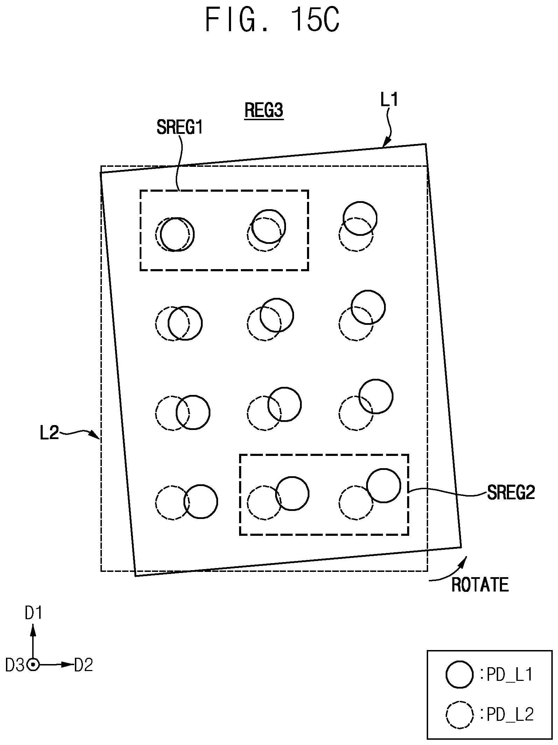

FIGS. 15A, 15B, and 15C are diagrams for describing an example of a memory device.

Referring to FIGS. 15A, 15B and 15C, various situations that may occur when the first semiconductor layer L1 and the second semiconductor layer L2 are connected by the bonding scheme are illustrated.

FIG. 15A illustrates an example of a first region REG1 of the memory cell array. In the first region REG1, the first and second semiconductor layers L1 and L2 are perfectly connected (e.g., bonded) without error. For example, as with the example of FIG. 3A, the misalignment between the first bonding pads PD_L1 of the first semiconductor layer L1 and the second bonding pads PD_L2 of the second semiconductor layer L2 may not occur, throughout the first region REG1.

FIG. 15B illustrates an example of a second region REG2 of the memory cell array. In the second region REG2, the first semiconductor layer L1 may be shifted to the right and connected (e.g., bonded) to the second semiconductor layer L2. For example, as with the example of FIG. 3C, the misalignment between the first and second bonding pads PD_L1 and PD_L2 may occur at the second level that is an uncompensable level, throughout the second region REG2.

FIG. 15C illustrates an example of a third region REG3 of the memory cell array. In the third region REG3, the first semiconductor layer L1 may be rotated counterclockwise and connected (e.g., bonded) to the second semiconductor layer L2. For example, in a first sub-region SREG1 of the third region REG3, the misalignment between the first and second bonding pads PD_L1 and PD_L2 may occur with the first level that is a compensable level. For example, in a second sub-region SREG2 of the third region REG3, the misalignment between the first and second bonding pads PD_L1 and PD_L2 may occur at the second level that is an uncompensable level.

As illustrated in FIG. 15B, if the degree of the misalignment of the bonding pads is uniform in the entire specific region REG2, the operation of detecting the defects and the feedback operation may be performed for the entire specific region REG2 by testing only some sub-region of the specific region REG2. As illustrated in FIG. 15C, if the degree of the misalignment of the bonding pads is not uniform in the specific region REG3, each sub-region included in the specific region REG3 may be tested, and the operation of detecting the defects and the feedback operation may be performed for each sub-region.

In some implementations, a relationship or correspondence between the regions REG1, REG2 and REG3 and the sub-regions SREG1 and SREG2 in FIGS. 15A, 15B, and 15C may be similar to a relationship or correspondence between the bank, block and mat described with reference to FIGS. 5A, 5B, and 5C. For example, when the regions REG1, REG2 and REG3 correspond to the bank, the sub-regions SREG1 and SREG2 may correspond to the block or the mat. For example, when the regions REG1, REG2 and REG3 correspond to the block, the sub-regions SREG1 and SREG2 may correspond to the mat.

FIGS. 16A, 16B, 16C, and 16D are diagrams for describing an example of an operation of a memory device.

Referring to FIGS. 16A and 16B, examples where the usage of a sub-region or region including the bonding pads is screened or blocked are illustrated when the misalignment between the bonding pads has occurred with the second level that is an uncompensable level.

For example, when a misalignment between bonding pads included in a first mat MAT1-1 among a plurality of mats MAT1-1, MAT1-2, ..., MAT1-y included in a first block BLK11 has occurred with the second level that is an uncompensable level, the usage of the first mat MAT1-1 may be screened or blocked as illustrated in FIG. 16A, and/or the usage of the first block BLK11 including the first mat MAT1-1 may be screened or blocked as illustrated in FIG. 16B.

Referring to FIGS. 16C and 16D, examples where a sub-region or region including the bonding pads is repaired to or replaced with another sub-region or another region are illustrated when the misalignment between the bonding pads has occurred with the second level that is an uncompensable level.

For example, when a misalignment between bonding pads included in a first mat MAT1-1 among a plurality of mats MAT1-1, MAT1-2, ..., MAT1-y included in a first block BLK11 or BLK12 has occurred with the second level that is an uncompensable level, the first mat MAT1-1 may be repaired to or replaced with a redundant mat RPMAT1 included in the first block BLK12 as illustrated in FIG. 16C, and/or the first block BLK11 including the first mat MAT1-1 may be repaired to or replaced with a redundant block RPBLK11 including redundant mats RPMAT1-1, RPMAT1-2, ..., RPMAT1-y as illustrated in FIG. 16D.

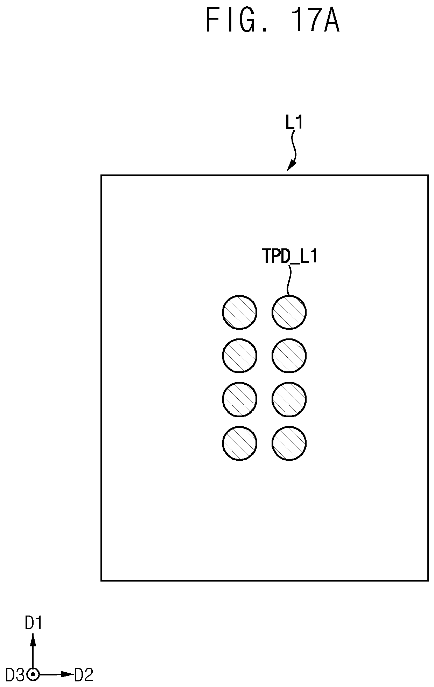

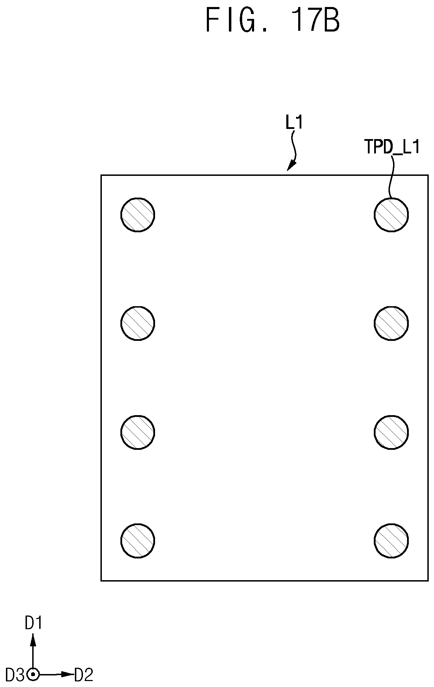

FIGS. 17A and 17B are diagrams for describing an example of a memory device.

Referring to FIG. 17A, in some implementations, the test pads TPD_L1 may be arranged to correspond to a center (or central region) of the first semiconductor layer L1. Although not illustrated in detail, as with the test pads TPD_L1, the test pads TPD_L2 included in the second semiconductor layer L2 may also be arranged to correspond to a center of the second semiconductor layer L2.

Referring to FIG. 17B, in some implementations, the test pads TPD_L1 may be arranged to correspond to at least one edge of the first semiconductor layer L1. Although not illustrated in detail, as with the test pads TPD_L1, the test pads TPD_L2 included in the second semiconductor layer L2 may also be arranged to correspond to at least one edge of the second semiconductor layer L2.

In some implementations, the test operations (e.g., determining or detecting the misalignment) using the test pads and the test circuit may be performed during manufacturing process of the memory device. In some implementations, the feedback operations (e.g., screening, repairing, adjusting operating conditions, etc.) using the test circuit may be performed during actual operation of the memory device.

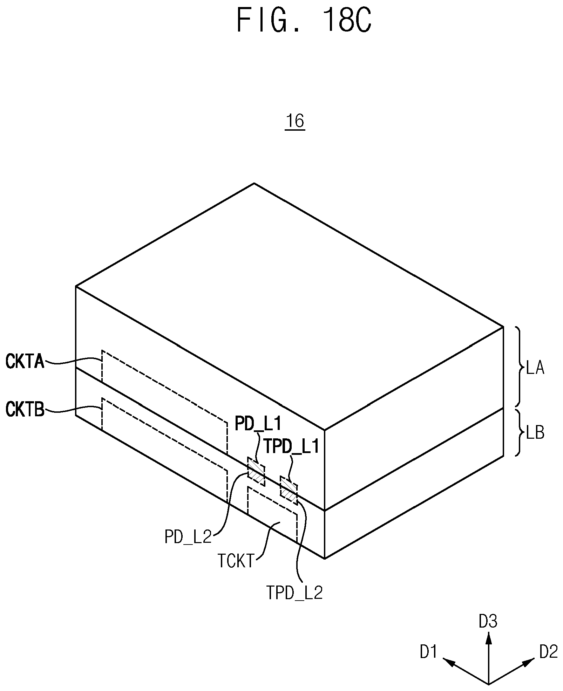

FIGS. 18A, 18B, and 18C are example perspective views of a memory device and a semiconductor device. The descriptions repeated with FIG. 1 will be omitted.

Referring to FIG. 18A, a memory device 12 includes a first semiconductor layer L1, a second semiconductor layer L2 and a third semiconductor layer L3. An example of FIG. 18A may be substantially the same as the example of FIG. 1, except that the memory device 12 further includes the third semiconductor layer L3.

The first semiconductor layer L1, the second semiconductor layer L2 and the third semiconductor layer L3 are disposed or stacked in the third direction D3. Although FIG. 18A illustrates an example where the first semiconductor layer L1 and the third semiconductor layer L3 are disposed on and below the second semiconductor layer L2, respectively, implementations are not limited thereto. For example, both the first and third semiconductor layers L1 and L3 may be disposed on or below the second semiconductor layer L2.

As with the first semiconductor layer L1, the third semiconductor layer L3 may include a memory cell array MCA, and may be referred to as a memory cell region. For example, the memory cell array MCA included in the first semiconductor layer L1 may be referred to as a first memory cell array, and the memory cell array MCA included in the third semiconductor layer L3 may be referred to as a second memory cell array.

The first bonding pad PD_L1 and the first test pad TPD_L1 of the first semiconductor layer L1 may be connected to a second bonding pad PD1_L2 and a second test pad TPD1_L2 of the second semiconductor layer L2, respectively.

The third semiconductor layer L3 may further include a third bonding pad PD_L3 and a third test pad TPD_L3. The second semiconductor layer L2 may further include a fourth bonding pad PD2_L2 connected to the third bonding pad PD_L3, and a fourth test pad TPD2_L2 connected to the third test pad TPD_L3. The test circuit TCKT may further receive a second test signal through the third and fourth test pads TPD_L3 and TPD2_L2. Based on the second test signal, the test circuit TCKT may further generate and store a second test result signal that represents a misalignment between the third and fourth bonding pads PD_L3 and PD2_L2. Based on the second test result signal, the test circuit TCKT may compensate for the operation of the peripheral circuit PCKT.

Referring to FIG. 18B, a memory device 14 includes a first semiconductor layer L1, a second semiconductor layer L2 and a fourth semiconductor layer L4. An example of FIG. 18B may be substantially the same as the example of FIG. 1, except that the memory device 14 further includes the fourth semiconductor layer L4.

The first semiconductor layer L1, the second semiconductor layer L2 and the fourth semiconductor layer L4 are disposed or stacked in the third direction D3. Although FIG. 18B illustrates an example where the fourth semiconductor layer L4 and the second semiconductor layer L2 are disposed on and below the first semiconductor layer L1, respectively, implementations are not limited thereto. For example, both the second and fourth semiconductor layers L2 and L4 may be disposed on or below the first semiconductor layer L1.

As with the second semiconductor layer L2, the fourth semiconductor layer L4 may include a peripheral circuit PCKT, and may be referred to as a peripheral circuit region. For example, the peripheral circuit PCKT included in the second semiconductor layer L2 may be referred to as a first peripheral circuit, and the peripheral circuit PCKT included in the fourth semiconductor layer L4 may be referred to as a second peripheral circuit.

A first bonding pad PD1_L1 and a first test pad TPD1_L1 of the first semiconductor layer L1 may be connected to the second bonding pad PD_L2 and the second test pad TPD_L2 of the second semiconductor layer L2, respectively.

The first semiconductor layer L1 may further include a fifth bonding pad PD2_L1 and a fifth test pad TPD2_L1. The fourth semiconductor layer L4 may further include a sixth bonding pad PD_L4 connected to the fifth bonding pad PD2_L1, a sixth test pad TPD_L4 connected to the fifth test pad TPD2_L1, and a test circuit TCKT. The test circuit TCKT of the fourth semiconductor layer L4 may receive a third test signal through the fifth and sixth test pads TPD2_L1 and TPD_L4. Based on the third test signal, the test circuit TCKT of the fourth semiconductor layer L4 may generate and store a third test result signal that represents a misalignment between the fifth and sixth bonding pads PD2_L1 and PD_L4. Based on the third test result signal, the test circuit TCKT of the fourth semiconductor layer L4 may compensate for the operation of the peripheral circuit PCKT of the fourth semiconductor layer L4.

Although not illustrated in detail, a memory device may include four or more semiconductor layers that are stacked.

Referring to FIG. 18C, a semiconductor device 16 includes a first semiconductor layer LA and a second semiconductor layer LB.

The first semiconductor layer LA and the second semiconductor layer LB are disposed or stacked in the third direction D3. The first semiconductor layer LA includes a first circuit CKTA, a first bonding pad PD_L1 and a first test pad TPD_L1. The second semiconductor layer LB includes a second circuit CKTB, a second bonding pad PD_L2, a second test pad TPD_L2 and a test circuit TCKT. The first circuit CKTA and the second circuit CKTB may be electrically connected to each other, and may be interoperable with each other. The first bonding pad PD_L1, the first test pad TPD_L1, the second bonding pad PD_L2, the second test pad TPD_L2 and the test circuit TCKT may be substantially the same as those described with reference to FIG. 1.

In some implementations, a semiconductor device may include three semiconductor layers that are stacked as described with reference to FIGS. 18A and 18B, or may include four or more semiconductor layers that are stacked.

In some implementations, a semiconductor device may include two semiconductor layers (e.g., layers L1 and L2) stacked as described. The first and second semiconductor layers may be disposed or stacked in the third direction. The first bonding pad PD_L1 and the first test pad TPD_L1 of the first semiconductor layer L1 may be connected to a second bonding pad PD1_L2 and a second test pad TPD1_L2 of the second semiconductor layer L2, respectively, as previously described. The first semiconductor layer L1 may further include a third bonding pad PD_L3 and a third test pad TPD_L3. The second semiconductor layer L2 may further include a fourth bonding pad PD2_L2 connected to the third bonding pad PD_L3, and a fourth test pad TPD2_L2 connected to the third test pad TPD_L3. The test circuit TCKT may further receive a second test signal through the third and fourth test pads TPD_L3 and TPD2_L2. Based on the second test signal, the test circuit TCKT may further generate and store a second test result signal that represents a misalignment between the third and fourth bonding pads PD_L3 and PD2_L2. Based on the second test result signal, the test circuit TCKT may compensate for the operation of the peripheral circuit PCKT.

As described above, the structure or configuration that detects and compensates the misalignment between the semiconductor layers using the test pads and the test circuit may be applied or employed not only to the memory device having the COP structure but also to an arbitrary semiconductor device in which different wafers are connected by the bonding scheme.

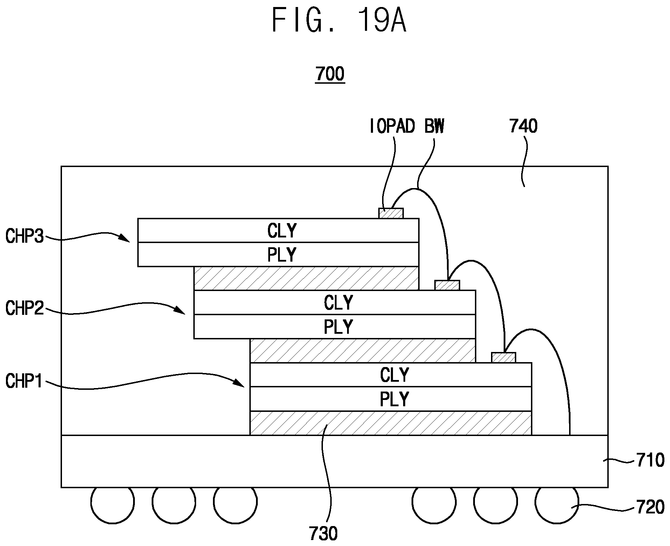

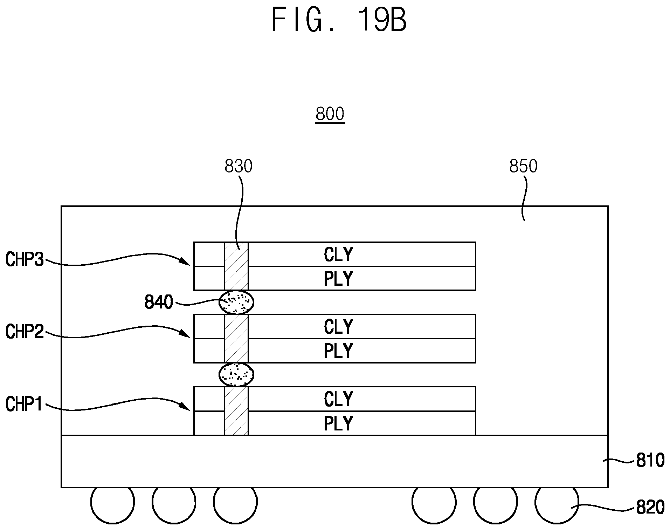

FIGS. 19A and 19B are cross-sectional views of an example of a memory package.

Referring to FIG. 19A, a memory package 700 includes a base substrate 710 and a plurality of memory chips CHP1, CHP2 and CHP3 stacked on the base substrate 710.

Each of the memory chips CHP1 to CHP3 may include a memory cell layer CLY and a peripheral circuit layer PLY, and may further include a plurality of I/O pads IOPAD. The memory cell layer CLY and the peripheral circuit layer PLY may correspond to the first semiconductor layer L1 and the second semiconductor layer L2 described with reference to FIG. 1, respectively, and further may include said elements described herein to be included in the first semiconductor layer L1 and the second semiconductor layer L2, respectively, according to any of the implementations described herein. Each of the memory chips CHP1 to CHP3 may include the memory device.

In some implementations, the memory chips CHP1 to CHP3 may be stacked on the base substrate 710 such that a surface on which the plurality of I/O pads IOPAD are formed faces upwards. In some implementations, with respect to each of the memory chips CHP1 to CHP3, the plurality of I/O pads IOPAD may be arranged near one side of the semiconductor substrate. As such, the memory chips CHP1 to CHP3 may be stacked scalariformly, that is, in a step shape, such that the plurality of I/O pads IOPAD of each memory chip may be exposed. In such stacked state, the memory chips CHP1 to CHP3 may be electrically connected to the base substrate 710 through a plurality of bonding wires BW.

The stacked memory chips CHP1 to CHP3 and the plurality of bonding wires BW may be fixed by a sealing member 740, and adhesive members 730 may intervene between the base substrate 710 and the memory chips CHP1 to CHP3. Conductive bumps 720 may be formed on a bottom surface of the base substrate 710 for electrical connections to an external device.

Referring to FIG. 19B, a memory package 800 includes a base substrate 810 and the plurality of memory chips CHP1 to CHP3 stacked on the base substrate 810. The descriptions repeated with FIG. 19A will be omitted.

Each of the memory chips CHP1 to CHP3 may include the memory cell layer CLY and the peripheral circuit layer PLY, and may further include a plurality of through silicon vias (TSVs) 830.

In some implementations, with respect to each of the memory chips CHP1 to CHP3, the plurality of TSVs 830 may be arranged at the same locations in each memory chip. As such, the memory chips CHP1 to CHP3 may be stacked such that the plurality of TSVs 830 of each memory chip may be completely overlapped (e.g., arrangements of the plurality of TSVs 830 may be perfectly matched in the memory chips CHP1 to CHP3). In such stacked state, the memory chips CHP1 to CHP3 may be electrically connected to one another and the base substrate 810 through the plurality of TSVs 830 and conductive material 840.

Conductive bumps 820 and a sealing member 850 may be substantially the same as the conductive bumps 720 and the sealing member 740 in FIG. 19A.

FIG. 20 is a block diagram illustrating an example of a memory system.

Referring to FIG. 20, a memory system 1000 includes a memory controller 1200 and a memory device 1400. The memory system 1000 may further include a plurality of signal lines 1300 that electrically connect the memory controller 1200 with the memory device 1400.

The memory device 1400 is controlled by the memory controller 1200. For example, based on requests from a host, the memory controller 1200 may store (e.g., write or program) data into the memory device 1400, or may retrieve (e.g., read or sense) data from the memory device 1400. The memory device 1400 may be the memory device, and may include test pads TPD and a test circuit TCKT that are used to detect and compensate a misalignment of two or more semiconductor layers connected by the bonding scheme.

The plurality of signal lines 1300 may include control lines, command lines, address lines, data input/output (I/O) lines and power lines. The memory controller 1200 may transmit a command CMD, an address ADDR and a control signal CTRL to the memory device 1400 via the command lines, the address lines and the control lines, may exchange a data signal DS with the memory device 1400 via the data I/O lines, and may transmit a power supply voltage PWR to the memory device 1400 via the power lines. Although not illustrated in detail, the plurality of signal lines 1300 may further include data strobe signal (DQS) lines for transmitting a DQS signal.

Although implementations are described based on the memory packages 700 and 800 including memory chips CHP1 to CHP3 and the memory system 1000 including the memory device 1400, implementations are not limited thereto. For example, implementations may be implemented in the form of a semiconductor package and a semiconductor system including the semiconductor device described with reference to FIG. 18C.

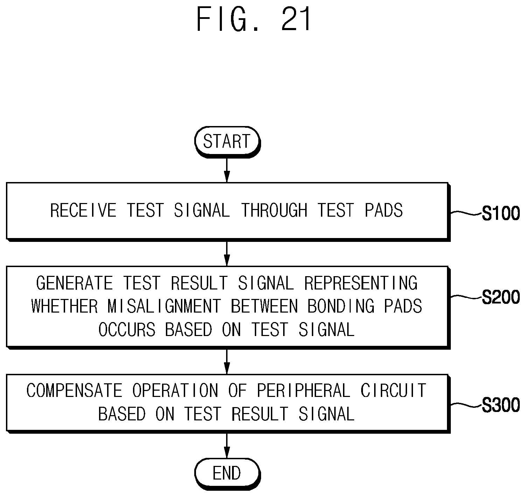

FIG. 21 is a flowchart illustrating an example of a method of operating a memory device.

Referring to FIG. 21, in a method of operating a memory device, a test signal is received through test pads that are included in different semiconductor layers and connected to each other (operation S100), a test result signal, which represents a misalignment between bonding pads that are included in the different semiconductor layers and connected to each other, is generated based on the test signal (operation S200), and an operation of a peripheral circuit included in the memory device is compensated based on the test result signal (operation S300). The memory device may be the memory device described with reference to FIGS. 1 through 18. In some implementations, the method of FIG. 21 may be described as a method of operating the semiconductor device described with reference to FIG. 18C.

The implementations may be applied to various electronic devices and systems that include the memory devices and the semiconductor devices. For example, the implementations may be applied to systems such as a personal computer (PC), a server computer, a data center, a workstation, a mobile phone, a smart phone, a tablet computer, a laptop computer, a personal digital assistant (PDA), a portable multimedia player (PMP), a digital camera, a portable game console, a music player, a camcorder, a video player, a navigation device, a wearable device, an internet of things (IoT) device, an internet of everything (IoE) device, an e-book reader, a virtual reality (VR) device, an augmented reality (AR) device, a robotic device, a drone, etc.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

The foregoing is illustrative of implementations and is not to be construed as limiting thereof. Although some implementations have been described, those skilled in the art will readily appreciate that many modifications are possible within the scope of the appended claims.

## Claims

1. A semiconductor device (10, 200) comprising:
a first semiconductor layer (L1) including:
a first circuit,
a first bonding pad (PD_L1), and
a first test pad (TPD_L1); and
a second semiconductor layer (L2) disposed with respect to the first semiconductor layer (L1) in a vertical direction (D3), the second semiconductor layer (L2) including:
a second circuit interoperable with the first circuit,
a second bonding pad (PD_L2) connected to the first bonding pad (PD_L1),
a second test pad (TPD_L2) connected to the first test pad (TPD_L1), and
a test circuit (TCKT) configured to check a connection state of the first bonding (PD_L1) pad and the second bonding pad (PD_L2),
wherein the test circuit (TCKT) is configured to:
receive a first test signal (TS) through the first test pad (TPD_L1) and the second test pad (TPD_L2),
generate a first test result signal (TRS) based on the first test signal (TS), and
compensate an operation of the second circuit based on the first test result signal (TRS), wherein the test circuit (TCKT) is configured to adjust a sensing time and/or operating voltage of the second circuit based on the first test result signal (TRS) to compensate the operation, and
wherein the first test result signal (TRS) represents a misalignment between the first bonding pad (PD_L1) and the second bonding pad (PD_L2).

2. The semiconductor device (10, 200) of claim 1,
wherein the first semiconductor layer (L1) includes:
a third bonding pad (PD_L3); and
a third test pad (TPD_L3),
wherein the second semiconductor layer (L2) includes:
a fourth bonding pad (PD2_L2) connected to the third bonding pad (PD_L3); and
a fourth test pad (TPD2_L2) connected to the third test pad (TPD_L3), and
wherein the test circuit (TCKT) is configured to receive a second test signal through the third test pad (TPD_L3) and the fourth test pad (TPD2_L2).

3. The semiconductor device (10, 200) of claim 2,
wherein the third test pad (TPD_L3) and the fourth test pad (TPD2_L2) are connected to the test circuit (TCKT) together with the first test pad (TPD_L1) and the second test pad (TPD_L2),
wherein the test circuit (TCKT) is configured to generate the first test result signal (TRS) based on the first test signal (TS) and the second test signal, and
wherein the first test result signal (TRS) further represents a second misalignment between the third bonding pad (PD_L3) and the fourth bonding pad (PD2_L2).

4. The semiconductor device (10, 200) of claim 2,
wherein the third test pad (TPD_L3) and the fourth test pad (TPD2_L2) are connected to the test circuit (TCKT) independently from the first test pad (TPD_L1) and the second test pad (TPD_L2),
wherein the test circuit (TCKT) is configured to:
generate a second test result signal based on the second test signal, and
compensate an operation of the first circuit or the operation of the second circuit based on the first test result signal (TRS) and the second test result signal, and
wherein the second test result signal represents a third misalignment between the third bonding pad (PD_L3) and the fourth bonding pad (PD2_L2).

5. The semiconductor device (10, 200) of any of claims 2 to 4,
wherein the first circuit includes a plurality of banks,
wherein the first bonding pad (PD_L1), the second bonding pad (PD_L2), the first test pad (TPD_L1), and the second test pad (TPD_L2) are included in a first bank (BANK1) of the plurality of banks, and
wherein the third bonding pad (PD_L3), the fourth bonding pad (PD2_L2), the third test pad (TPD_L3), and the fourth test pad (TPD2_L2) are included in a second bank (BANK2), different from the first bank (BANK1), of the plurality of banks.

6. The semiconductor device (10, 200) of any of claims 2 to 4,
wherein the first circuit includes a plurality of banks,
wherein each bank of the plurality of banks includes a plurality of blocks,
wherein the first bonding pad (PD_L1), the second bonding pad (PD_L2), the first test pad (TPD_L1), and the second test pad (TPD_L2) are included in a first block (BLK1) of the plurality of blocks, and
wherein the third bonding pad (PD_L3), the fourth bonding pad (PD2_L2), the third test pad (TPD_L3), and the fourth test pad (TPD2_L2) are included in a second block (BLK2), different from the first block (BLK1), of the plurality of blocks.

7. The semiconductor device (10, 200) of any of claims 2 to 4,
wherein the first circuit includes a plurality of banks,
wherein each bank of the plurality of banks includes a plurality of blocks,
wherein each block of the plurality of blocks includes a plurality of mats,
wherein the first bonding pad (PD_L1), the second bonding pad (PD_L2), the first test pad (TPD_L1), and the second test pad (TPD_L2) are included in a first mat (MAT1) of the plurality of mats, and
wherein the third bonding pad (PD_L3), the fourth bonding pad (PD2_L2), the third test pad (TPD_L3), and the fourth test pad (TPD2_L2) are included in a second mat (MAT2), different from the first mat (MAT1), of the plurality of mats.

8. The semiconductor device (10, 200) of any preceding claim, wherein the test circuit (TCKT) includes:
a plurality of sense amplifiers (410) configured to generate the first test result signal (TRS) based on the first test signal (TS); and
a storage circuit configured to store the first test result signal (TRS).

9. The semiconductor device (10, 200) of claim 8, wherein each sense amplifier of the plurality of sense amplifiers (410) is configured to operate based on a respective reference voltage of a plurality of reference voltages, and the plurality of reference voltages are different from each other.

10. The semiconductor device (10, 200) of claim 9, wherein the plurality of sense amplifiers (410a) includes:
a first sense amplifier (411a) configured to generate a first bit (BIT1) of the first test result signal (TRS) based on a first reference voltage (VSREF1) and the first test signal (TS);
a second sense amplifier (413a) configured to generate a second bit (BIT2) of the first test result signal (TRS) based on a second reference voltage (VSREF2) and the first test signal (TS), a voltage level (SREF2) of the second reference voltage (VSREF2) being higher than a voltage level (SREF1) of the first reference voltage (VSREF1); and
a third sense amplifier (415a) configured to generate a third bit (BIT3) of the first test result signal (TRS) based on a third reference voltage (VSREF3) and the first test signal (TS), a voltage level (SREF3) of the third reference voltage (VSREF3) being higher than the voltage level (SREF2) of the second reference voltage (VSREF2).

11. The semiconductor device (10, 200) of claim 8, wherein each sense amplifier of the plurality of sense amplifiers (410b) is configured to operate with a respective sensing time of a plurality of sensing times, and the plurality of sensing times are different from each other.

12. The semiconductor device (10, 200) of claim 11, wherein the plurality of sense amplifiers (410b) includes:
a first sense amplifier (411b) configured to generate a first bit (BIT1) of the first test result signal (TRS) based on a first reference voltage (VSREF) and the first test signal (TS) during a first sensing time (tSA1);
a second sense amplifier (413b) configured to generate a second bit (BIT2) of the first test result signal (TRS) based on the first reference voltage (VSREF) and the first test signal (TS) during a second sensing time (tSA2), the second sensing time (tSA2) being longer than the first sensing time (tSA1); and
a third sense amplifier (415b) configured to generate a third bit (BIT3) of the first test result signal (TRS) based on the first reference voltage (VSREF) and the first test signal (TS) during a third sensing time (tSA3), the third sensing time (tSA3) being longer than the second sensing time (tSA2).

13. The semiconductor device (10, 200) of any of claims 8 to 12,
wherein the first semiconductor layer (L1) includes:
a third bonding pad (PD_L3); and
a third test pad (TPD_L3),
wherein the second semiconductor layer (L2) includes:
a fourth bonding pad (PD2_L2) connected to the third bonding pad (PD_L3); and
a fourth test pad (TPD2_L2) connected to the third test pad (TPD_L3),
wherein the test circuit (TCKT) includes:
a multiplexer (240, 430) configured to select one of the first test signal (TS) and a second test signal, the second test signal being received through the third test pad (TPD_L3) and the fourth test pad (TPD2_L2),
wherein the plurality of sense amplifiers (410) are configured to generate a second test result signal based on the second test signal, and
wherein the storage circuit is configured to store the second test result signal.

14. The semiconductor device (10, 200) of any preceding claim,
wherein, based on the first test result signal (TRS) having a first value, the semiconductor device (10, 200) is configured to determine that the first misalignment between the first bonding pad (PD_L1) and the second bonding pad (PD_L2) does not occur,
wherein, based on the first test result signal (TRS) having a second value different from the first value, the semiconductor device (10, 200) is configured to determine that the first misalignment between the first bonding pad (PD_L1) and the second bonding pad (PD_L2) has occurred with a first level that is a compensable level, and
wherein, based on the first test result signal (TRS) having a third value different from the first value and the second value, the semiconductor device is configured to determine that the first misalignment between the first bonding pad (PD_L1) and the second bonding pad (PD_L2) has occurred with a second level that is an uncompensable level.

15. The semiconductor device (10, 200) of any preceding claim,
wherein the first circuit comprises a memory cell array (MCA) connected to a plurality of wordlines (WL) and a plurality of bitlines (BL), the plurality of wordlines (WL) extending in a first direction (D1), the plurality of bitlines (BL) extending in a second direction (D2), the second direction (D2) crossing the first direction (D1), and
wherein the second circuit comprises a peripheral circuit (PCKT, 201) configured to control the memory cell array (MCA).

## Patentansprüche

1. Halbleitervorrichtung (10, 200), umfassend:
eine erste Halbleiterschicht (L1), die einschließt:
eine erste Schaltung,
ein erstes Bondpad (PD_L1), und
ein erstes Testpad (TPD_L1); und
eine zweite Halbleiterschicht (L2), die relativ zur ersten Halbleiterschicht (L1) in einer vertikalen Richtung (D3) angeordnet ist, wobei die zweite Halbleiterschicht (L2) einschließt:
eine zweite Schaltung, die mit der ersten Schaltung zusammenwirken kann,
ein zweites Bondpad (PD_L2), das mit dem ersten Bondpad (PD_L1) verbunden ist,
ein zweites Testpad (TPD_L2), das mit dem ersten Testpad (TPD_L1) verbunden ist, und
eine Testschaltung (TCKT), die dafür konfiguriert ist, einen Verbindungszustand zwischen dem ersten Bondpad (PD_L1) und dem zweiten Bondpad (PD_L2) zu überprüfen,
wobei die Testschaltung (TCKT) dafür konfiguriert ist:
über das erste Testpad (TPD_L1) und das zweite Testpad (TPD_L2) ein erstes Testsignal (TS) zu empfangen,
auf der Grundlage des ersten Testsignals (TS) ein erstes Testergebnissignal (TRS) zu erzeugen, und
auf der Grundlage des ersten Testergebnissignals (TRS) einen Betrieb der zweiten Schaltung zu kompensieren, wobei die Testschaltung (TCKT) dafür konfiguriert ist, eine Lesezeit und/oder eine Betriebsspannung der zweiten Schaltung auf der Grundlage des ersten Testergebnissignals (TRS) nachzuregeln, um den Betrieb zu kompensieren, und
wobei das erste Testergebnissignal (TRS) eine Fehlausrichtung zwischen dem ersten Bondpad (PD_L1) und dem zweiten Bondpad (PD_L2) repräsentiert.

2. Halbleitervorrichtung (10, 200) nach Anspruch 1,
wobei die erste Halbleiterschicht (L1) einschließt:
ein drittes Bondpad (PD_L3); und
ein drittes Testpad (TPD_L3),
wobei die zweite Halbleiterschicht (L2) einschließt:
ein viertes Bondpad (PD2_L2), das mit dem dritten Bondpad (PD_L3) verbunden ist; und
ein viertes Testpad (TPD2_L2), das mit dem dritten Testpad (TPD_L3) verbunden ist, und
wobei die Testschaltung (TCKT) dafür konfiguriert ist, über das dritte Testpad (TPD_L3) und das vierte Testpad (TPD2_L2) ein zweites Testsignal zu empfangen.

3. Halbleitervorrichtung (10, 200) nach Anspruch 2,
wobei das dritte Testpad (TPD_L3) und das vierte Testpad (TPD2_L2) zusammen mit dem ersten Testpad (TPD_L1) und dem zweiten Testpad (TPD_L2) mit der Testschaltung (TCKT) verbunden sind,
wobei die Testschaltung (TCKT) dafür konfiguriert ist, das erste Testergebnissignal (TRS) auf der Grundlage des ersten Testsignals (TS) und des zweiten Testsignals zu erzeugen, und
wobei das erste Testergebnissignal (TRS) ferner eine zweite Fehlausrichtung zwischen dem dritten Bondpad (PD_L3) und dem vierten Bondpad (PD2_L2) repräsentiert.

4. Halbleitervorrichtung (10, 200) nach Anspruch 2,
wobei das dritte Testpad (TPD_L3) und das vierte Testpad (TPD2_L2) unabhängig von dem ersten Testpad (TPD_L1) und dem zweiten Testpad (TPD_L2) mit der Testschaltung (TCKT) verbunden sind,
wobei die Testschaltung (TCKT) dafür konfiguriert ist:
auf der Grundlage des zweiten Testsignals ein zweites Testergebnissignal zu erzeugen, und
auf der Grundlage des ersten Testergebnissignals (TRS) und des zweiten Testergebnissignals einen Betrieb der ersten Schaltung oder den Betrieb der zweiten Schaltung zu kompensieren, und
wobei das zweite Testergebnissignal eine dritte Fehlausrichtung zwischen dem dritten Bondpad (PD_L3) und dem vierten Bondpad (PD2_L2) repräsentiert.

5. Halbleitervorrichtung (10, 200) nach einem der Ansprüche 2 bis 4,
wobei die erste Schaltung eine Vielzahl von Bänken einschließt,
wobei das erste Bondpad (PD_L1), das zweite Bondpad (PD_L2), das erste Testpad (TPD_L1) und das zweite Testpad (TPD_L2) in einer ersten Bank (BANK1) der Vielzahl von Bänken eingeschlossen sind, und
wobei das dritte Bondpad (PD_L3), das vierte Bondpad (PD2_L2), das dritte Testpad (TPD_L3) und das vierte Testpad (TPD2_L2) in einer zweiten Bank (BANK2) der Vielzahl von Bänken, die sich von der ersten Bank (BANK1) unterscheidet, eingeschlossen sind.

6. Halbleitervorrichtung (10, 200) nach einem der Ansprüche 2 bis 4,
wobei die erste Schaltung eine Vielzahl von Bänken einschließt,
wobei jede Bank der Vielzahl von Bänken eine Vielzahl von Blöcken einschließt,
wobei das erste Bondpad (PD_L1), das zweite Bondpad (PD_L2), das erste Testpad (TPD_L1) und das zweite Testpad (TPD_L2) in einem ersten Block (BLK1) der Vielzahl von Blöcken eingeschlossen sind, und
wobei das dritte Bondpad (PD_L3), das vierte Bondpad (PD2_L2), das dritte Testpad (TPD_L3) und das vierte Testpad (TPD2_L2) in einem zweiten Block (BLK2) der Vielzahl von Blöcken, der sich vom ersten Block (BLK1) unterscheidet, eingeschlossen sind.

7. Halbleitervorrichtung (10, 200) nach einem der Ansprüche 2 bis 4,
wobei die erste Schaltung eine Vielzahl von Bänken einschließt,
wobei jede Bank der Vielzahl von Bänken eine Vielzahl von Blöcken einschließt,
wobei jeder Block der Vielzahl von Blöcken eine Vielzahl von Matten einschließt,
wobei das erste Bondpad (PD_L1), das zweite Bondpad (PD_L2), das erste Testpad (TPD_L1) und das zweite Testpad (TPD_L2) in einer ersten Matte (MAT1) der Vielzahl von Matten eingeschlossen sind, und
wobei das dritte Bondpad (PD_L3), das vierte Bondpad (PD2_L2), das dritte Testpad (TPD_L3) und das vierte Testpad (TPD2_L2) in einer zweiten Matte (MAT2) der Vielzahl von Matten, die sich von der ersten Matte (MAT1) unterscheidet, eingeschlossen sind.

8. Halbleitervorrichtung (10, 200) nach einem vorstehenden Anspruch, wobei die Testschaltung (TCKT) einschließt:
eine Vielzahl von Leseverstärkern (410), die dafür konfiguriert sind, das erste Testergebnissignal (TRS) auf der Grundlage des ersten Testsignals (TS) zu erzeugen; und
eine Speicherschaltung, die dafür konfiguriert ist, das erste Testergebnissignal (TRS) zu speichern.

9. Halbleitervorrichtung (10, 200) nach Anspruch 8, wobei jeder Leseverstärker der Vielzahl von Leseverstärkern (410) dafür konfiguriert ist, auf der Grundlage einer jeweiligen Referenzspannung aus einer Vielzahl von Referenzspannungen zu arbeiten, und wobei sich die Vielzahl von Referenzspannungen voneinander unterscheiden.

10. Halbleitervorrichtung (10, 200) nach Anspruch 9, wobei die Vielzahl von Leseverstärkern (410a) einschließt:
einen ersten Leseverstärker (411a), der dafür konfiguriert ist, ein erstes Bit (BIT1) des ersten Testergebnissignals (TRS) auf der Grundlage einer ersten Referenzspannung (VSREF1) und des ersten Testsignals (TS) zu erzeugen;
einen zweiten Leseverstärker (413a), der dafür konfiguriert ist, ein zweites Bit (BIT2) des ersten Testergebnissignals (TRS) auf der Grundlage einer zweiten Referenzspannung (VSREF2) und des ersten Testsignals (TS) zu erzeugen, wobei ein Spannungspegel (SREF2) der zweiten Referenzspannung (VSREF2) höher ist als ein Spannungspegel (SREF1) der ersten Referenzspannung (VSREF1); und
einen dritten Leseverstärker (415a), der dafür konfiguriert ist, ein drittes Bit (BIT3) des ersten Testergebnissignals (TRS) auf der Grundlage einer dritten Referenzspannung (VSREF3) und des ersten Testsignals (TS) zu erzeugen, wobei ein Spannungspegel (SREF3) der dritten Referenzspannung (VSREF3) höher ist als der Spannungspegel (SREF2) der zweiten Referenzspannung (VSREF2).

11. Halbleitervorrichtung (10, 200) nach Anspruch 8, wobei jeder Leseverstärker der Vielzahl von Leseverstärkern (410b) dafür konfiguriert ist, mit einer jeweiligen Lesezeit aus einer Vielzahl von Lesezeiten zu arbeiten, und sich die Vielzahl von Lesezeiten voneinander unterscheiden.

12. Halbleitervorrichtung (10, 200) nach Anspruch 11, wobei die Vielzahl von Leseverstärkern (410b) einschließt:
einen ersten Leseverstärker (411b), der dafür konfiguriert ist, während einer ersten Lesezeit (tSA1) ein erstes Bit (BIT1) des ersten Testergebnissignals (TRS) auf der Grundlage einer ersten Referenzspannung (VSREF) und des ersten Testsignals (TS) zu erzeugen;
einen zweiten Leseverstärker (413b), der dafür konfiguriert ist, während einer zweiten Lesezeit (tSA2) ein zweites Bit (BIT2) des ersten Testergebnissignals (TRS) auf der Grundlage der ersten Referenzspannung (VSREF) und des ersten Testsignals (TS) zu erzeugen, wobei die zweite Lesezeit (tSA2) länger ist als die erste Lesezeit (tSA1); und
einen dritten Leseverstärker (415b), der dafür konfiguriert ist, während einer dritten Lesezeit (tSA3) ein drittes Bit (BIT3) des ersten Testergebnissignals (TRS) auf der Grundlage der ersten Referenzspannung (VSREF) und des ersten Testsignals (TS) zu erzeugen, wobei die dritte Lesezeit (tSA3) länger ist als die zweite Lesezeit (tSA2).

13. Halbleitervorrichtung (10, 200) nach einem der Ansprüche 8 bis 12,
wobei die erste Halbleiterschicht (L1) einschließt:
ein drittes Bondpad (PD_L3); und
ein drittes Testpad (TPD_L3),
wobei die zweite Halbleiterschicht (L2) einschließt:
ein viertes Bondpad (PD2_L2), das mit dem dritten Bondpad (PD_L3) verbunden ist; und
ein viertes Testpad (TPD2_L2), das mit dem dritten Testpad (TPD_L3) verbunden ist,
wobei die Testschaltung (TCKT) einschließt:
einen Multiplexer (240, 430), der dafür konfiguriert ist, eines des ersten Testsignals (TS) und eines zweiten Testsignals auszuwählen, wobei das zweite Testsignal über das dritte Testpad (TPD_L3) und das vierte Testpad (TPD2_L2) empfangen wird,
wobei die Vielzahl von Leseverstärkern (410) dafür konfiguriert ist, auf der Grundlage des zweiten Testsignals ein zweites Testergebnissignal zu erzeugen, und
wobei die Speicherschaltung dafür konfiguriert ist, das zweite Testergebnissignal zu speichern.

14. Halbleitervorrichtung (10, 200) nach einem vorstehenden Anspruch,
wobei, aufgrund dessen, dass das erste Testergebnissignal (TRS) einen ersten Wert aufweist, die Halbleitervorrichtung (10, 200) dafür konfiguriert ist, zu bestimmen, dass die erste Fehlausrichtung zwischen dem ersten Bondpad (PD_L1) und dem zweiten Bondpad (PD_L2) nicht vorliegt,
wobei, aufgrund dessen, dass das erste Testergebnissignal (TRS) einen zweiten Wert aufweist, der sich vom ersten Wert unterscheidet, die Halbleitervorrichtung (10, 200) dafür konfiguriert ist, zu bestimmen, dass die erste Fehlausrichtung zwischen dem ersten Bondpad (PD_L1) und dem zweiten Bondpad (PD_L2) mit einem ersten Ausmaß aufgetreten ist, das ein kompensierbares Ausmaß ist, und
wobei, aufgrund dessen, dass das erste Testergebnissignal (TRS) einen dritten Wert aufweist, der sich vom ersten Wert und vom zweiten Wert unterscheidet, die Halbleitervorrichtung dafür konfiguriert ist, zu bestimmen, dass die erste Fehlausrichtung zwischen dem ersten Bondpad (PD_L1) und dem zweiten Bondpad (PD_L2) mit einem zweiten Ausmaß aufgetreten ist, das ein nicht kompensierbares Ausmaß ist.

15. Halbleitervorrichtung (10, 200) nach einem vorstehenden Anspruch,
wobei die erste Schaltung eine Speicherzellenanordnung (MCA) umfasst, die mit einer Vielzahl von Wortleitungen (WL) und einer Vielzahl von Bitleitungen (BL) verbunden ist, wobei die Vielzahl von Wortleitungen (WL) sich in einer ersten Richtung (D1) erstreckt, wobei die Vielzahl von Bitleitungen (BL) sich in einer zweiten Richtung (D2) erstreckt, wobei die zweite Richtung (D2) die erste Richtung (D1) kreuzt, und
wobei die zweite Schaltung eine Peripherieschaltung (PCKT, 201) umfasst, die dafür konfiguriert ist, die Speicherzellenanordnung (MCA) zu steuern.

## Revendications

1. Dispositif semi-conducteur (10, 200) comprenant :
une première couche semi-conductrice (L1) incluant :
un premier circuit,
un premier plot de liaison (PD_L1), et
un premier plot de test (TPD_L1) ; et
une deuxième couche semi-conductrice (L2) disposée par rapport à la première couche semi-conductrice (L1) dans une direction verticale (D3), la deuxième couche semi-conductrice (L2) incluant :
un deuxième circuit interopérable avec le premier circuit,
un plot de liaison (PD_L2) connecté au premier plot de liaison (PD_L1),
un deuxième plot de test (TPD_L2) connecté au premier plot de test (TPD_L1), et
un circuit de test (TCKT) configuré pour vérifier un état de connexion du premier plot de liaison (PD_L1) et le deuxième plot de liaison (PD_L2),
dans lequel le circuit de test (TCKT) est configuré pour :
recevoir un premier signal de test (TS) via le premier plot de test (TPD_L1) et le deuxième plot de test (TPD_L2),
générer un premier signal de résultat de test (TRS) sur la base du premier signal de test (TS), et
compenser un fonctionnement du deuxième circuit sur la base du premier signal de résultat de test (TRS), dans lequel le circuit de test (TCKT) est configuré pour ajuster un temps de détection et/ou une tension de fonctionnement du deuxième circuit sur la base du premier signal de résultat de test (TRS) pour compenser le fonctionnement, et
dans lequel le premier signal de résultat de test (TRS) représente un mauvais alignement entre le premier plot de liaison (PD_L1) et le deuxième plot de liaison (PD_L2).

2. Dispositif semi-conducteur (10, 200) selon la revendication 1,
dans lequel la première couche semi-conductrice (L1) inclut :
un troisième plot de liaison (PD_L3) ; et
un troisième plot de test (TPD_L3),
dans lequel la deuxième couche semi-conductrice (L2) inclut :
un quatrième plot de liaison (PD2_L2) connecté au troisième plot de liaison (PD_L3) ; et
un quatrième plot de test (TPD2_L2) connecté au troisième plot de test (TPD_L3), et
dans lequel le circuit de test (TCKT) est configuré pour recevoir un second signal de test via le troisième plot de test (TPD_L3) et le quatrième plot de test (TPD2_L2).

3. Dispositif semi-conducteur (10, 200) selon la revendication 2,
dans lequel le troisième plot de test (TPD_L3) et le quatrième plot de test (TPD2_L2) sont connectés ensemble au circuit de test (TCKT) ainsi qu'au premier plot de test (TPD_L1) et au deuxième plot de test (TPD_L2),
dans lequel le circuit de test (TCKT) est configuré pour générer le premier signal de résultat de test (TRS) à partir du premier signal de test (TS) et du second signal de test, et
dans lequel le premier signal de résultat de test (TRS) représente en outre un deuxième mauvais alignement entre le troisième plot de liaison (PD_L3) et le quatrième plot de liaison (PD2_L2).

4. Dispositif semi-conducteur (10, 200) selon la revendication 2,
dans lequel le troisième plot de test (TPD_L3) et le quatrième plot de test (TPD2_L2) sont connectés au circuit de test (TCKT) indépendamment du premier plot de test (TPD_L1) et du deuxième plot de test (TPD_L2),
dans lequel le circuit de test (TCKT) est configuré pour :
générer un second signal de résultat de test sur la base du second signal de test, et
compenser un fonctionnement du premier circuit ou le fonctionnement du deuxième circuit sur la base du premier signal de résultat de test (TRS) et du second signal de résultat de test, et
dans lequel le second signal de résultat de test représente un troisième mauvais alignement entre le troisième plot de liaison (PD_L3) et le quatrième plot de liaison (PD2_L2).

5. Dispositif semi-conducteur (10, 200) selon l'une quelconque des revendications 2 à 4,
dans lequel le premier circuit inclut une pluralité de bancs,
dans lequel le premier plot de liaison (PD_L1), le deuxième plot de liaison (PD_L2), le premier plot de test (TPD_L1), et le deuxième plot de test (TPD_L2) sont inclus dans un premier banc (BANK1) parmi la pluralité de bancs, et
dans lequel le troisième plot de liaison (PD_L3), le quatrième plot de liaison (PD2_L2), le troisième plot de test (TPD_L3), et le quatrième plot de test (TPD2_L2) sont inclus dans un second banc (BANK2), différent du premier banc (BANK1), de la pluralité de bancs.

6. Dispositif semi-conducteur (10, 200) selon l'une quelconque des revendications 2 à 4,
dans lequel le premier circuit inclut une pluralité de bancs,
dans lequel chaque banc de la pluralité de bancs inclut une pluralité de blocs,
dans lequel le premier plot de liaison (PD_L1), le deuxième plot de liaison (PD_L2), le premier plot de test (TPD_L1), et le deuxième plot de test (TPD_L2) sont inclus dans un premier bloc (BLK1) parmi la pluralité de blocs, et
dans lequel le troisième plot de liaison (PD_L3), le quatrième plot de liaison (PD2_L2), le troisième plot de test (TPD_L3), et le quatrième plot de test (TPD2_L2) sont inclus dans un second bloc (BLK2), différent du premier bloc (BLK1), de la pluralité de blocs.

7. Dispositif semi-conducteur (10, 200) selon l'une quelconque des revendications 2 à 4,
dans lequel le premier circuit inclut une pluralité de bancs,
dans lequel chaque banc de la pluralité de bancs inclut une pluralité de blocs,
dans lequel chaque bloc de la pluralité de blocs inclut une pluralité de tapis,
dans lequel le premier plot de liaison (PD_L1), le deuxième plot de liaison (PD_L2), le premier plot de test (TPD_L1), et le deuxième plot de test (TPD_L2) sont inclus dans un premier tapis (MAT1) parmi la pluralité de tapis, et
dans lequel le troisième plot de liaison (PD_L3), le quatrième plot de liaison (PD2_L2), le troisième plot de test (TPD_L3), et le quatrième plot de test (TPD2_L2) sont inclus dans un second tapis (MAT2), différent du premier tapis (MAT1), de la pluralité de tapis.

8. Dispositif semi-conducteur (10, 200) selon une quelconque revendication précédente, dans lequel le circuit de test (TCKT) inclut :
une pluralité d'amplificateurs de détection (410) configurés pour générer le premier signal de résultat de test (TRS) sur la base du premier signal de test (TS) ; et
un circuit de stockage configuré pour stocker le premier signal de résultat de test (TRS).

9. Dispositif semi-conducteur (10, 200) selon la revendication 8, dans lequel chaque amplificateur de détection de la pluralité d'amplificateurs de détection (410) est configuré pour fonctionner sur la base d'une tension de référence respective d'une pluralité de tensions de référence, et la pluralité de tensions de référence sont différentes les unes des autres.

10. Dispositif semi-conducteur (10, 200) selon la revendication 9, dans lequel la pluralité d'amplificateurs de détection (410a) inclut :
un premier amplificateur de détection (411a) configuré pour générer un premier bit (BIT1) du premier signal de résultat de test (TRS) basé sur une première tension de référence (VSREF1) et le premier signal de test (TS) ;
un deuxième amplificateur de détection (413a) configuré pour générer un deuxième bit (BIT2) du premier signal de résultat de test (TRS) basé sur une deuxième tension de référence (VSREF2) et le premier signal de test (TS), un niveau de tension (SREF2) de la deuxième tension de référence (VSREF2) étant supérieur à un niveau de tension (SREF1) de la première tension de référence (VSREF1) ; et
un troisième amplificateur de détection (415a) configuré pour générer un troisième bit (BIT3) du premier signal de résultat de test (TRS) basé sur une troisième tension de référence (VSREF3) et le premier signal de test (TS), un niveau de tension (SREF3) de la troisième tension de référence (VSREF3) étant supérieur au niveau de tension (SREF2) de la deuxième tension de référence (VSREF2).

11. Dispositif semi-conducteur (10, 200) selon la revendication 8, dans lequel chaque amplificateur de détection de la pluralité d'amplificateurs de détection (410b) est configuré pour fonctionner avec un temps de détection respectif d'une pluralité de temps de détection, et la pluralité de temps de détection sont différentes les uns des autres.

12. Dispositif semi-conducteur (10, 200) selon la revendication 11, dans lequel la pluralité d'amplificateurs de détection (410b) inclut :
un premier amplificateur de détection (411b) configuré pour générer un premier bit (BIT1) du premier signal de résultat de test (TRS) basé sur une première tension de référence (VSREF) pendant un premier temps de détection (tSA1) ;
un deuxième amplificateur de détection (413b) configuré pour générer un deuxième bit (BIT2) du premier signal de résultat de test (TRS) basé sur la première tension de référence (VSREF) et le premier signal de test (TS) pendant un deuxième temps de détection (tSA2), le deuxième temps de détection (tSA2) étant plus long que le premier temps de détection (tSA1) ; et
un troisième amplificateur de détection (415b) configuré pour générer un troisième bit (BIT3) du premier signal de résultat de test (TRS) basé sur la première tension de référence (VSREF) et le premier signal de test (TS) pendant un troisième temps de détection (tSA3), le troisième temps de détection (tSA3) étant plus long que le deuxième temps de détection (tSA2).

13. Dispositif semi-conducteur (10, 200) selon l'une quelconque des revendications 8 à 12,
dans lequel la première couche semi-conductrice (L1) inclut :
un troisième plot de liaison (PD_L3) ; et
un troisième plot de test (TPD_L3),
dans lequel la deuxième couche semi-conductrice (L2) inclut :
un quatrième plot de liaison (PD2_L2) connecté au troisième plot de liaison (PD_L3) ; et
un quatrième plot de test (TPD2_L2) connecté au troisième plot de test (TPD_L3),
dans lequel le circuit de test (TCKT) inclut :
un multiplexeur (240, 430) configuré pour sélectionner un parmi le premier signal de test (TS) et un second signal de test, le second signal de test étant reçu via le troisième plot de test (TPD_L3) et le quatrième plot de test (TPD2_L2),
dans lequel la pluralité d'amplificateurs de détection (410) sont configurés pour générer un deuxième signal de résultat de test basé sur le deuxième signal de test, et
dans lequel le circuit de stockage est configuré pour stocker le deuxième signal de résultat de test.

14. Dispositif semi-conducteur (10, 200) selon une quelconque revendication précédente,
dans lequel, sur la base du premier signal de résultat de test (TRS) présentant une première valeur, le dispositif semi-conducteur (10, 200) est configuré pour déterminer que le premier mauvais alignement entre le premier plot de liaison (PD_L1) et le deuxième plot de liaison (PD_L2) ne se produit pas,
dans lequel, sur la base du premier signal de résultat de test (TRS) présentant une deuxième valeur différente de la première valeur, le dispositif semi-conducteur (10, 200) est configuré pour déterminer que le premier mauvais alignement entre le premier plot de liaison (PD_L1) et le deuxième plot de liaison (PD_L2) s'est produit avec un premier niveau qui est compensable, et
dans lequel, sur la base du premier signal de résultat de test (TRS) présentant une troisième valeur différente de la première valeur et de la deuxième valeur, le dispositif semi-conducteur est configuré pour déterminer que le premier mauvais alignement entre le premier plot de liaison (PD_L1) et le deuxième plot de liaison (PD_L2) s'est produit avec un second niveau qui est non compensable.

15. Dispositif semi-conducteur (10, 200) selon une quelconque revendication précédente,
dans lequel le premier circuit comprend un réseau de cellules de mémoire (MCA) connecté à une pluralité de lignes de mots (WL) et à une pluralité de lignes de bits (BL), la pluralité de lignes de mots (WL) s'étendant dans une première direction (D1), la pluralité de lignes de bits (BL) s'étendant dans une seconde direction (D2), la seconde direction (D2) recoupant la première direction (D1), et
dans lequel le deuxième circuit comprend un circuit périphérique (PCKT, 201) configuré pour commander le réseau de cellules de mémoire (MCA).
